(19) Europäisches Patentamt
European Patent Office
Office européen des brevets

(11) **EP 2 816 360 B1**

(12) **FASCICULE DE BREVET EUROPEEN**

(45) Date de publication et mention
de la délivrance du brevet:
**27.11.2024 Bulletin 2024/48**

(21) Numéro de dépôt: **14172570.5**

(22) Date de dépôt: **16.06.2014**

(51) Classification Internationale des Brevets (IPC):
**G01R 19/25** (2006.01)    **H02J 13/00** (2006.01)

(52) Classification Coopérative des Brevets (CPC):
**H02J 13/00028; G01R 19/2513; H02J 13/00034;**
Y02E 60/00; Y04S 10/16

(54) **Système de calcul d'une grandeur électrique, poste de transformation comprenant un tel système et procédé de calcul d'une grandeur électrique avec un tel système**

Berechnungsverfahren einer elektrischen Messgröße, Transformatoreinheit, die ein solches System umfasst, und Berechnungsverfahren einer elektrischen Messgröße mit einem solchen System

System for calculating an electrical variable, transformer station including such a system and method for calculating an electrical magnitude with such a system

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.06.2013 FR 1355657**

(43) Date de publication de la demande:
**24.12.2014 Bulletin 2014/52**

(73) Titulaire: **Schneider Electric Industries SAS**
**92500 Rueil-Malmaison (FR)**

(72) Inventeurs:
• **Coutelou, Olivier**
**38050 Grenoble Cedex 09 (FR)**
• **Sillans, Damien**
**38050 Grenoble Cedex 09 (FR)**
• **Gaillard, Maxime**
**38050 Grenoble Cedex 09 (FR)**

(74) Mandataire: **Lavoix**
**62, rue de Bonnel**
**69448 Lyon Cedex 03 (FR)**

(56) Documents cités:
EP-A1- 2 549 280          EP-A1- 2 685 267
WO-A1-2013/017663     WO-A2-2010/083164
US-A- 5 995 911            US-A1- 2010 179 779

**Description**

La présente invention concerne un système de calcul d'une grandeur électrique relative à une installation électrique comprenant un conducteur électrique primaire et plusieurs conducteurs électriques secondaires reliés électriquement au conducteur électrique primaire, le système de calcul comprenant :

- un premier module comportant un émetteur radioélectrique,
- une pluralité de deuxièmes modules, chacun comportant un émetteur-récepteur radioélectrique et un capteur de courant propre à mesurer l'intensité d'un courant circulant dans un conducteur correspondant parmi les conducteurs électriques primaire et secondaires.

La présente invention concerne également un poste de transformation d'un courant électrique présentant une première tension alternative en un courant électrique et présentant une deuxième tension alternative, ce poste de transformation comprenant un tel système de calcul.

La présente invention concerne également un procédé de calcul d'une grandeur électrique avec un tel système de calcul.

On connaît du document WO 2010/119332 A1 un système de calcul du type précité. Le système de calcul comprend des modules de calcul d'une énergie électrique ou d'une puissance électrique, une base de données de stockage des valeurs calculées de l'énergie ou de la puissance et un module de gestion propre à fournir, à des clients distants, des informations correspondant aux valeurs mesurées et calculées. Les modules de calcul sont reliés par l'intermédiaire de liaisons radioélectriques à une passerelle de communication elle-même connectée à un réseau. La base de données, le module de gestion et les clients distants sont également reliés au réseau. Chaque module de calcul est propre à calculer l'énergie électrique et la puissance du courant circulant dans un conducteur électrique. Il comporte un capteur d'intensité, une unité de traitement propre à calculer l'énergie et la puissance électrique et un émetteur-récepteur radioélectrique. Chaque module de calcul est synchronisé avec la passerelle de communication par l'intermédiaire d'une horloge.

On connaît également de WO 2013/017663 A1 un système de calcul du type précité permettant de synchroniser une mesure de courant faite par l'un des deuxièmes modules avec une mesure de tension faite par le premier module.

Toutefois, de tels systèmes de calcul nécessitent la présence d'un capteur de courant associé à chaque conducteur électrique pour lequel l'énergie et la puissance électrique sont calculés. De plus, de tels systèmes sont relativement complexes et coûteux.

Le but de l'invention est donc de proposer un système de calcul d'une grandeur électrique de type intensité, énergie ou puissance électrique pour un conducteur électrique auquel aucun capteur de courant n'est associé. L'invention permet par exemple dans une installation électrique comprenant un conducteur électrique primaire et plusieurs conducteurs électriques secondaires de mesurer l'intensité électrique dans tous les conducteurs électriques secondaires et de calculer l'intensité électrique dans le conducteur primaire à partir de ces valeurs mesurées.

A cet effet, l'invention a pour objet un système de calcul selon la revendication 1.

Selon des aspects avantageux de l'invention, le système de calcul comprend en outre une ou plusieurs des caractéristiques optionnelles des revendications 2 à 9 :

L'invention a également pour objet un poste de transformation selon la revendication 10.

L'invention a également pour objet un procédé de calcul selon la revendication 11.

Suivant d'autres aspects avantageux de l'invention, le procédé de calcul comprend en outre une ou plusieurs des caractéristiques optionnelles des revendications 12 à 15.

Grâce à l'invention, la mesure quasi-simultanée de l'intensité par chaque capteur de courant de chaque deuxième module permet de réaliser des opérations, telles que des additions, sur les différentes intensités complexes instantanées mesurées, ainsi que sur des puissances complexes instantanées et/ou sur des énergies calculées entre autres à partir des différentes intensités mesurées.

L'invention sera mieux comprise et d'autres avantages de celle-ci apparaîtront plus clairement à la lumière de la description qui va suivre, donnée uniquement à titre d'exemple non limitatif, et faite en se référant aux dessins annexés sur lesquels :

- la figure 1 est une représentation schématique d'un poste de transformation comprenant un premier tableau, un deuxième tableau connecté au premier tableau par l'intermédiaire d'un transformateur et un système de calcul d'une grandeur électrique conforme à l'invention,
- la figure 2 est une représentation schématique du système de calcul de la figure 1, le système de calcul comprenant des premier, deuxièmes et troisième modules, le deuxième tableau comprenant trois départs électriques,
- la figure 3 est une représentation schématique du deuxième module de la figure 2,
- la figure 4 est un chronogramme représentant les instants d'émission et de réception d'un premier message, celui-ci étant émis par le premier module à destination de chaque deuxième module,

- la figure 5 est un chronogramme représentant l'émission des premier et deuxièmes messages et leur traitement,
- la figure 6 est un organigramme des étapes d'un procédé de calcul de la grandeur électrique selon un premier mode de réalisation,
- les figures 7 à 9 sont des vues analogues à celle de la figure 6 selon des deuxième, troisième et respectivement quatrième modes de réalisation.

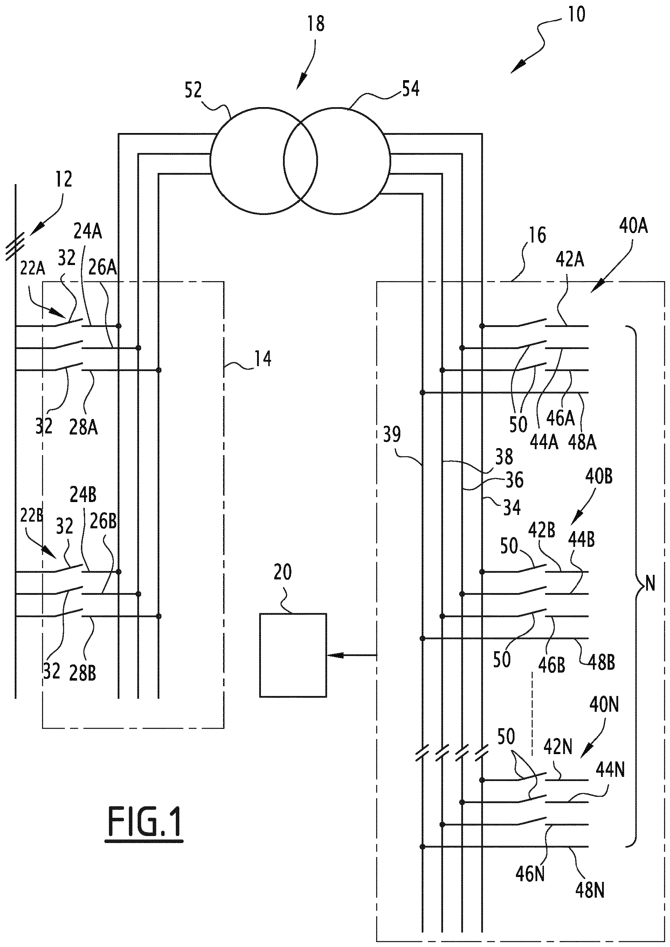

Sur la figure 1, un poste de transformation 10 connecté à un réseau électrique 12 comprend un premier tableau 14, un deuxième tableau 16, un transformateur électrique 18 connecté entre le premier tableau 14 et le deuxième tableau 16 et un système 20 de calcul d'une grandeur électrique telle qu'une énergie électrique, une puissance électrique ou une intensité électrique.

Le poste de transformation 10 est propre à transformer le courant électrique délivré par le réseau 12 et présentant une première tension alternative, en un courant électrique présentant une deuxième tension alternative.

Le réseau électrique 12 est un réseau alternatif, tel qu'un réseau triphasé. Le réseau électrique 12 est un réseau moyenne tension, c'est-à-dire un réseau dont la tension est supérieure à 1000 volts et inférieure à 50000 volts. La première tension triphasée est alors une moyenne tension.

En variante, le réseau électrique 12 est un réseau haute tension, c'est-à-dire un réseau dont la tension est supérieure à 50000 volts. Autrement dit, la première tension triphasée est une haute tension.

Le premier tableau 14 comporte plusieurs arrivées 22A, 22B, chaque arrivée 22A, 22B comportant un premier 24A, 24B, un deuxième 26A, 26B, et un troisième 28A, 28B conducteurs d'arrivée. Chaque premier, deuxième, troisième conducteur d'arrivée 24A, 24B, 26A, 26B, 28A, 28B est relié au réseau électrique par l'intermédiaire d'un disjoncteur d'arrivée 32 respectif. Le courant triphasé circulant dans les conducteurs d'arrivée 24A, 24B, 26A, 26B, 28A, 28B correspondants présente la première tension triphasée.

Le deuxième tableau 16 comprend un premier 34, un deuxième 36, un troisième 38 et un quatrième 39 conducteur primaire et une pluralité N de départs 40A, 40B, ... 40N, à savoir un premier départ 40A, un deuxième départ 40B, ... , un Nième départ 40N, chaque départ 40A, 40B, ..., 40N étant propre à délivrer une tension triphasée.

Chaque départ 40A, 40B, ...,40N est un départ basse tension c'est-à-dire un départ dont la tension est inférieure à 1000 volts. La deuxième tension triphasée est alors une basse tension.

En variante, chaque départ 40A, 40B, ..., 40N est un départ moyenne tension, c'est-à-dire un départ dont la tension est supérieure à 1000 volts et inférieure à 50000 volts. Autrement dit, la deuxième tension triphasée est une moyenne tension.

Le premier départ 40A comporte un premier 42A, un deuxième 44A, un troisième 46A et un quatrième 48A conducteurs secondaires et trois disjoncteurs de départ 50. Les premier, deuxième et troisième conducteurs secondaires 42A, 44A, 46A sont respectivement reliés aux premier, deuxième et troisième conducteurs primaires 34, 36, 38 par l'intermédiaire d'un disjoncteur de départ 50 correspondant. Le quatrième conducteur secondaire 48A est directement connecté au quatrième conducteur primaire 39.

Les conducteurs primaires de départ 34, 36, 38, et les conducteurs secondaires de départ 42A, 44A, 46A correspondants présentent sensiblement la même tension, à savoir respectivement une première tension V1, une deuxième tension V2 et une troisième tension V3 correspondants aux trois phases de la deuxième tension triphasée par rapport au conducteur de neutre 39.

Les autres départs 40B, ..., 40N sont identiques au premier départ 40A décrit précédemment, et comportent les mêmes éléments en remplaçant à chaque fois la lettre A par la lettre B, ..., N correspondante concernant les références des éléments.

Le transformateur électrique 18 est propre à transformer le courant issu du réseau électrique présentant la première tension alternative en le courant délivré au deuxième tableau 16 et présentant la deuxième tension alternative. Le transformateur électrique 18 comporte un enroulement primaire 52 connecté au premier tableau 14 et un enroulement secondaire 54 connecté au deuxième tableau 16.

Le système de calcul 20 est propre à calculer une grandeur électrique du type intensité, énergie électrique et/ou puissance instantanée électrique dans chaque conducteur secondaire de départ 42A, 44A, 46A, 48A, 42B, 44B, 46B, 48B..., 42N, 44N, 46N, 48N.

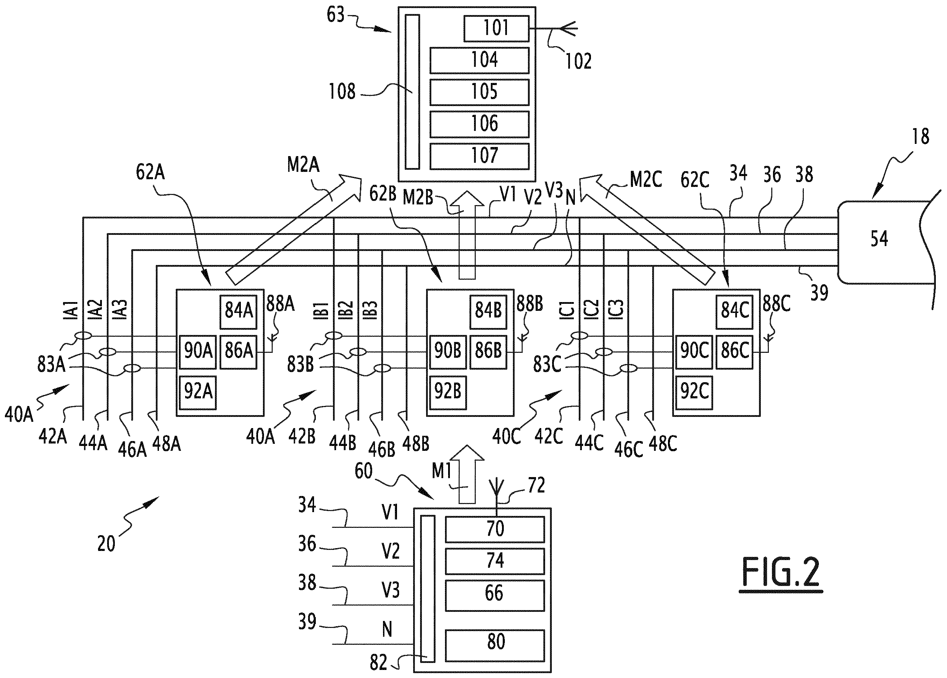

Dans la représentation de la figure 2, le deuxième tableau est représenté avec le nombre N de départs égal à 3. Ainsi, le deuxième tableau 16 comprend un premier 34, un deuxième 36, un troisième 38 et un quatrième 39 conducteurs primaires et trois départs 40A, 40B, 40C.

Le système de calcul 20, visible sur la figure 2, comprend un premier module 60 connecté aux conducteurs primaires 34, 36, 38, 39, trois deuxièmes modules 62A, 62B, 62C, à savoir un deuxième module 62A, 62B, 62C respectif pour chaque départ 40A, 40B, 40C, le deuxième module 62A, 62B, 62C étant connecté aux conducteurs secondaires de départ 42A, 44A, 46A, respectivement 42B, 44B, 46B et respectivement 44C, 46C, 46C. En complément, le système de calcul 20 comprend un troisième module 63.

Le premier module 60 comporte un organe de mesure 66, un émetteur radioélectrique 70, une antenne radioélectrique 72, un microcontrôleur 74, un bloc de communication 80 et un organe 82 d'alimentation électrique de ces différents éléments.

Le deuxième module 62A comporte, pour chacun des premier 42A, deuxième 44A et troisième 46A conducteurs secondaires, un capteur de courant 83A propre à mesurer l'intensité du courant circulant dans le conducteur secondaire 42A, 44A, 46A correspondant. Il comprend en complément un microcontrôleur 84A, un émetteur-récepteur radioélectrique 86A, une antenne radioélectrique 88A, un convertisseur analogique numérique 90A et un organe 92A d'alimentation électrique de ces éléments.

Les autres deuxièmes modules 62B, 62C sont identiques au deuxième module 62A décrit précédemment, et comportent les mêmes éléments en remplaçant à chaque fois la lettre A par la lettre B, C correspondante concernant les références des éléments.

Le troisième module 63 comporte un récepteur radioélectrique 101, une antenne radioélectrique 102, un organe de calcul 104, une unité 105 de stockage de données et d'horodatage, une interface homme-machine 106, un bloc de communication 107 et un organe 108 d'alimentation électrique de ces différents éléments.

L'organe de mesure 66 est propre à mesurer la fréquence F de la tension triphasée des conducteurs primaires 34, 36, 38.

L'émetteur radioélectrique 70 est de préférence conforme au protocole de communication ZIGBEE ou ZIGBEE GREEN POWER basé sur la norme IEEE-802.15.4. En variante, l'émetteur radioélectrique 70 est de préférence conforme à la norme IEEE-802.15.1 ou à la norme IEEE-802.15.2. En variante encore, l'émetteur radioélectrique 70 est de préférence conforme à la norme IEEE-802-11. Sans répondre à un standard IEEE, cet émetteur peut aussi être tout simplement conforme aux réglementations en vigueur dans chaque pays (solution de communication radio propriétaire).

L'antenne radioélectrique 72 est adaptée pour émettre des signaux radioélectriques à destination des antennes 88A, 88B, 88C des deuxièmes modules 62A, 62B, 62C. Autrement dit, le premier module 60 est relié à chacun des deuxièmes modules 62A, 62B, 62C par une liaison radioélectrique correspondante.

Le microcontrôleur 74 est apte à stocker et à exécuter un logiciel, non représenté, d'émission d'un premier message M1 à destination de chaque deuxième module 62A, 62B, 62C, le logiciel d'émission étant propre à coopérer avec l'émetteur radioélectrique 70 et l'antenne radioélectrique 72.

Le bloc de communication 80 permet une communication du premier module 60 avec un organe extérieur, non représenté, à l'aide d'une liaison de communication, de préférence standardisée, telle qu'une liaison de type Protocole ModBus Serial Line, ou ModBus TCP/IP ou encore tout autre protocole utilisant l'IP.

Le capteur de courant 83A est propre à mesurer une intensité respective parmi une première intensité IA1 circulant dans le premier conducteur secondaire de départ 42A, une deuxième intensité IA2 circulant dans le deuxième conducteur secondaire de départ 44A et une troisième intensité IA3 circulant dans le troisième conducteur secondaire de départ 46A.

En complément, le convertisseur analogique numérique 90A est propre à échantillonner, selon une fréquence d'échantillonnage $F_{ECH}$, les valeurs de l'intensité IA1, IA2, IA3 mesurées par le capteur de courant 83A. Ainsi, le convertisseur analogique numérique 90A, de même que les convertisseurs analogiques numérique 90B et 90C forment en outre un organe d'échantillonnage.

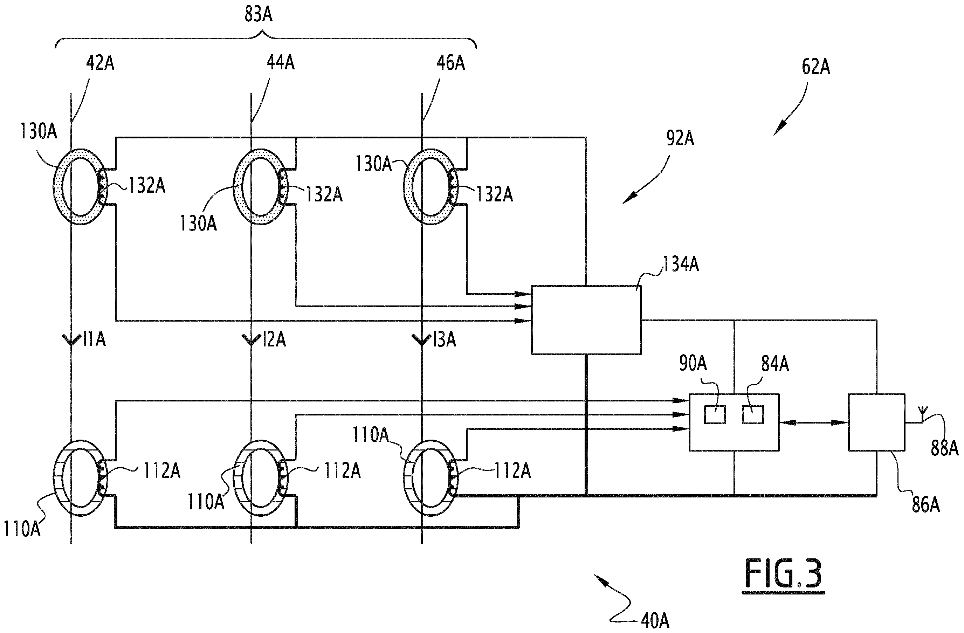

Le capteur de courant 83A comporte un premier tore 110A disposé autour du conducteur secondaire de départ 42A, 44A, 46A correspondant et un premier enroulement 112A agencé autour du premier tore, comme représenté sur la figure 3. La circulation du courant à travers le conducteur secondaire de départ correspondant est propre à engendrer un courant induit proportionnel à l'intensité du courant dans le premier enroulement 112A. Le premier tore 110A est un tore de Rogowski. Le premier tore 110A est de préférence un tore ouvrant afin de faciliter son agencement autour des conducteurs correspondants.

Le microcontrôleur 84A est apte à stocker et à exécuter un logiciel d'acquisition des valeurs échantillonnées par le convertisseur analogique numérique 90A des intensités respectives IA1, IA2, IA3, un logiciel de réception du premier message M1, un logiciel de compression des valeurs échantillonnées des première, deuxième et troisième intensités IA1, IA2, IA3 et un logiciel d'émission d'un deuxième message M2A à destination du troisième module 63, non représentés.

L'émetteur-récepteur radioélectrique 86A est du même type que l'émetteur radioélectrique 70.

L'antenne radioélectrique 88A, est adaptée pour recevoir des signaux radioélectriques de l'antenne 72 et également pour émettre des signaux radioélectriques à l'antenne 101.

L'organe d'alimentation 92A du deuxième module 62A comporte, pour chacun des premier 42A, deuxième 44A et troisième 46A conducteurs secondaires, un deuxième tore 130A disposé autour du conducteur secondaire 42A, 44A, 46A correspondant et un deuxième enroulement 132A agencé autour du deuxième tore. La circulation du courant dans le conducteur secondaire 42A, 44A, 46A correspondant est propre à engendrer un courant induit dans le deuxième enroulement 132A. Autrement dit, le deuxième module 62A est autoalimenté par chaque deuxième tore 130A et chaque deuxième enroulement 132A, qui récupèrent l'énergie magnétique et forment un transformateur de courant.

L'organe d'alimentation 92A comporte un convertisseur 134A connecté à chacun des deuxièmes enroulements 132A et propre à délivrer une tension prédéterminée à l'émetteur-récepteur radioélectrique 86A au microcontrôleur 84A et au convertisseur analogique numérique 90A. Chaque deuxième tore 130A est un tore en fer. Chaque deuxième tore 130A est de préférence un tore ouvrant afin de faciliter son agencement autour des conducteurs correspondants.

Autrement dit, le module secondaire 62A est autoalimenté par l'intermédiaire de l'organe d'alimentation 92A comportant les deuxièmes tores 130A adaptés pour récupérer l'énergie magnétique issue de la circulation du courant dans les conducteurs secondaires 42A, 44A, 46A correspondants.

Les éléments des autres deuxièmes modules 62B, 62C sont identiques aux éléments du deuxième module 62A décrits précédemment et comportent les mêmes sous-éléments en remplaçant chaque fois la lettre A par la lettre B, C, correspondante concernant les références des sous-éléments.

En variante, les deuxièmes modules 62A, 62B, 62C sont alimentés par le secteur, c'est-à-dire qu'ils ne sont pas autoalimentés.

Le récepteur radioélectrique 101 est du même type que l'émetteur radioélectrique 70.

L'antenne radioélectrique 102 est adaptée pour recevoir des signaux radioélectriques desdites antennes 88A, 88B, 88C.

L'organe de calcul 104 est propre à stocker et à exécuter un logiciel de réception des deuxièmes messages M2A, M2B, M2C et un logiciel de calcul d'une somme d'intensités ou de puissances à partir des données comprises dans les deuxièmes messages M2A, M2B, M2C.

L'unité 105 est apte à stocker et à horodater des données reçues ainsi que les résultats des calculs via les deuxièmes messages M2A, M2B, M2C.

L'interface homme-machine 106 du troisième module 63 comporte un écran d'affichage et un clavier de saisie, non représentés. En variante, l'interface homme-machine 106 comporte un écran tactile et la saisie de données est réalisée par l'intermédiaire de touches tactiles affichées à l'écran.

Le bloc de communication 107 est du même type que le bloc de communication 80.

Le système 20 de calcul présenté ci-dessus permet la mesure et le calcul des intensités ainsi que leur sommation, et le système 20 est, selon un mode de réalisation complémentaire de celui décrit précédemment, également propre à calculer des puissances électriques et des énergies électriques et à calculer des sommes de puissances électriques ou d'énergies électriques. Dans ce mode de réalisation complémentaire, l'organe de mesure 66 est propre à mesurer la tension du courant circulant dans les conducteurs primaires 34, 36, 38. Plus précisément, l'organe de mesure 66 est propre à mesurer la première tension V1 de la phase circulant à travers le premier conducteur primaire 34, également appelée phase numéro 1 et notée Phase_1, la deuxième tension V2 de la phase circulant à travers le deuxième conducteur primaire 36, également appelée phase numéro 2 et notée Phase_2, et la troisième tension V3 de la phase circulant à travers le troisième conducteur primaire 38, également appelée phase numéro 3 et notée Phase_3. Par ailleurs, l'organe d'alimentation 82 est propre à alimenter électriquement l'organe de mesure 66 à partir de la tension triphasée circulant à travers les conducteurs primaires 34, 36, 38.

Dans ce mode de réalisation complémentaire, le microcontrôleur 84A est apte à stocker et à exécuter un logiciel de calcul de l'énergie électrique EA1, EA2, EA3, de l'intensité IA1, IA2, IA3 circulant dans le conducteur secondaire 42A, 44A, 46A correspondant, et de la puissance instantanée QA1, QA2, QA3 du courant IA1, IA2, IA3 circulant dans le conducteur secondaire 42A, 44A, 46A correspondant.

Les éléments des autres deuxièmes modules 62B, 62C sont identiques aux éléments du deuxième module 62A décrits précédemment et comportent les mêmes sous-éléments en remplaçant chaque fois la lettre A par la lettre B, C, correspondante concernant les références des sous-éléments ou les grandeurs calculées par les sous-éléments.

L'organe de calcul 104 est apte à stocker et à exécuter un logiciel de calcul de sommes d'énergies électriques réelles EA1, EA2, EA3, EB1, EB2, EB3, EC1, EC2, EC3 et de puissances instantanées électriques complexes QA1, QA2, QA3, QB1, QB2, QB3, QC1, QC2, QC3 à partir des données reçues via les deuxièmes messages M2A, M2B, M2C.

Dans l'exemple de la figure 2, le système de calcul 20 comprend trois deuxièmes modules 62A, 62B, 62C et le transformateur dispose de trois départs 40A, 40B, 40C, et l'homme du métier comprendra que le système de calcul 20 comprend de manière générale N départs et N deuxièmes modules, N étant un nombre entier supérieur à 1.

Le fonctionnement du système de calcul 20 va désormais être expliqué et quatre modes de réalisation du procédé de calcul selon l'invention vont être successivement présentés.

Pour tous ces modes de réalisation, une étape commune est une étape d'initialisation, qui précède toutes les étapes qui seront décrites par la suite, et n'a pas été représentée sur les différentes figures. Cette étape initiale permet l'ordonnancement de l'envoi des deuxièmes messages M2A, M2B, M2C au troisième module 63. Dans cette étape initiale, le premier module 60 transmet aux deuxièmes modules 62A, 62B, 62C, un troisième message M3 spécifique à chaque deuxième module 62A, 62B, 62C et contenant un numéro d'ordre différent attribué à chaque deuxième module. Autrement dit, chaque deuxième module 62A, 62B, 62C reçoit de la part du premier module 60 un numéro d'ordre qu'il enregistre et qui détermine une période $P_{tension}$ de la tension triphasée à laquelle le deuxième module doit envoyer le deuxième message M2A, M2B, M2C.

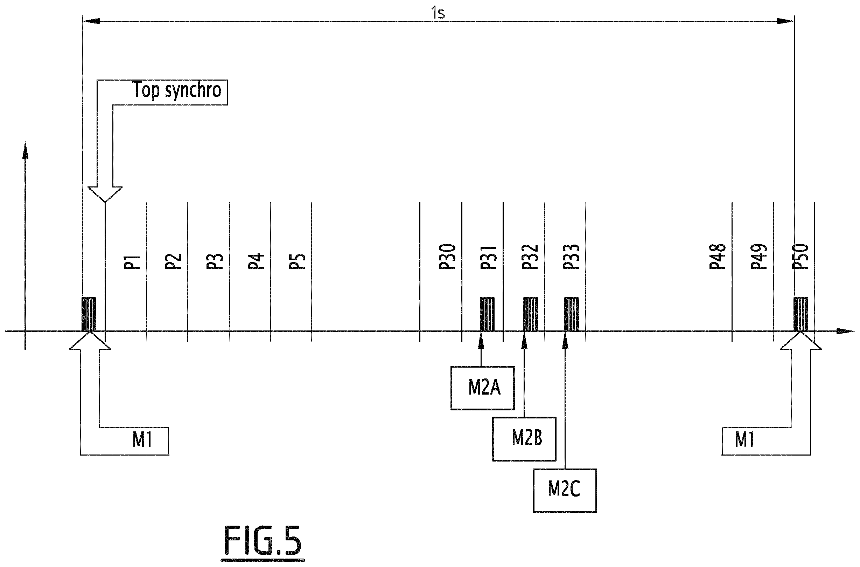

Comme représenté à la figure 5, le premier message M1 est émis toutes les secondes et durant chaque seconde les différentes étapes conduisant au calcul des grandeurs électriques voulues sont effectuées. Ainsi, si la période $P_{tension}$ de la tension triphasée est de 20 ms comme montré à la figure 5, cette seconde est divisée en 50 périodes notés P1, P2, .., P50. Durant ces périodes P1, P2, .., P50, les différentes tâches sont réparties et les différentes étapes du procédé de calcul sont effectuées. Les cinq premières périodes P1, P2, P3, P4, P5 correspondent à l'échantillonnage du courant et à la réalisation de la compression qui seront présentées par la suite. En outre, sachant qu'après l'initialisation et l'envoi du troisième message M3 les deuxièmes modules connaissent leur numéro d'ordre, les périodes d'émission des deuxièmes messages M2A, M2B, M2C sont connues. Ainsi, le deuxième module 62A possède le numéro d'ordre un et émet à la période 31 le message M2A, le deuxième module 62B possède le numéro d'ordre deux et émet à la période 32 le message M2B et ainsi de suite sachant que ces numéros d'ordre vont par exemple de 1 à 16, le poste de transformation 10 comportant par exemple un maximum de 16 départs. Dans l'exemple décrit, le poste de transformation 10 comporte trois deuxièmes modules 62A, 62B, 62C, et le numéro d'ordre est donc compris entre 1 et 3. Cet ordonnancement des deuxièmes modules 62A, 62B, 62C, et plus particulièrement des deuxièmes messages M2A, M2B, M2C qu'ils envoient, permet d'éviter une collision entre les différents deuxièmes messages M2A, M2B, M2C.

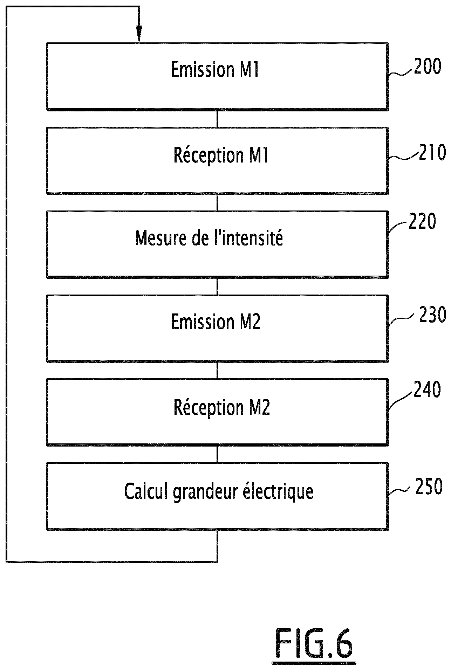

Selon un premier mode de réalisation du procédé de calcul, correspondant à la figure 6, le premier module 60, lors d'une première étape 200, émet le premier message M1 à destination de chacun des deuxièmes modules 62A, 62B, 62C, via l'antenne radioélectrique 72. Ce premier message M1 est un message de synchronisation de chaque capteur de courant 83A, 83B, 83C.

Le premier message M1 est de préférence émis périodiquement. La période d'émission $R_{émission}$ est prédéterminée, et de préférence égale à une seconde. Autrement dit, le premier message M1 est émis toutes les secondes comme visible à la figure 5.

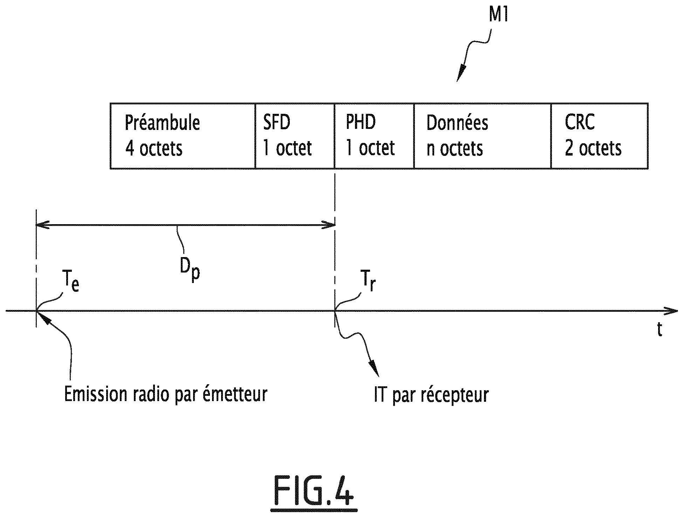

Le premier message M1 contient un top de synchronisation des capteurs de courant 83A, 83B, 83C. Plus précisément, par exemple, le premier message M1 comprend un champ d'en-tête, également appelé préambule, un champ SFD (de l'anglais Start of Frame Délimiter), un champ PHR (de l'anglais Physical Header), un champ de données et un champ CRC (de l'anglais Cyclic Redundancy Check). Le préambule présente une taille de 4 octets, les champs SFD et PHR présentent chacun une taille d'un octet, le champ de données est de taille variable, notée n octets, et le champ CRC a une taille de 2 octets. Dans l'exemple de réalisation de la figure 4, le premier message M1 est constitué du champ d'en-tête, du champ SFD, du champ PHR, du champ de données et du champ CRC. La réception du SFD par les modules 62A, 62B et 62C constitue le top de synchronisation (Figure 4).

En complément, lors de l'étape 200, le premier module 60 mesure les première, deuxième et troisième tensions V1, V2, V3 à l'aide de l'organe de mesure 66 et le champ de données du premier message M1 contient en outre les valeurs des tensions complexes V1, V2, V3.

Après émission du premier message M1, le premier module 60 attend un temps prédéterminé avant d'émettre à nouveau un premier message M1.

Les étapes propres à chaque deuxième module 62A, 62B, 62C vont maintenant être décrites.

Lors d'une étape 210 de réception du premier message M1, chaque deuxième module 62A, 62B, 62C attend le top de synchronisation de la part du premier message

M1. Autrement dit, chaque deuxième module 62A, 62B, 62C ouvre périodiquement des fenêtres de réception du premier message M1 jusqu'à ce qu'il reçoive le premier message M1. En cas de réception du premier message M1 le deuxième module 62A, 62B, 62C ouvrira une fenêtre d'écoute de quelques millisecondes du prochain premier message M1 un peu moins d'une seconde après la réception de ce premier message M1. En cas de non-réception du premier message M1, le deuxième module 62A, 62B, 62C ouvre à nouveau une fenêtre de réception du premier message M1 une seconde plus tard.

Plus précisément, lors de la réception du premier message M1, le deuxième module 62A, 62B, 62C détecte l'instant Tr de réception du champ SFD, la réception du champ SFD entrainant le déclenchement d'une interruption par le récepteur radioélectrique de chaque deuxième module 62A, 62B, 62C, immédiatement après la démodulation du SFD. La détection de l'instant de réception Tr permet alors de calculer si nécessaire l'instant Te auquel le premier message M1 a été émis par l'émetteur radioélectrique du premier module 60. L'instant d'émission Te est en effet égal à l'instant de réception Tr moins une durée Dp de propagation du premier message M1 via la liaison radioélectrique entre le premier module 60 et les deuxièmes modules 62A, 62B, 62C, la durée de propagation Dp étant fixe et connue pour une taille prédéterminée du champ de données du premier message M1.

Une fois le premier message M1 reçu par les antennes radioélectriques 88A, 88B, 88C, chaque deuxième module 62A, 62B, 62C mesure alors quasi-simultanément, avec une marge d'erreur de synchronisation de préférence inférieure à $10\mu s$, de préférence encore égale à $1\mu s$, lors d'une étape 220, et par l'intermédiaire de ses capteurs de courant 83A, 83B, 83C de ses convertisseurs analogiques numériques 90A, 90B, 90C et de son microcontrôleur 84A, 84B, 84C, les trois courants IA1, IA2, IA3, IB1, IB2, IB3, IC1, IC2, IC3 des trois phases, et échantillonne les valeurs mesurées. Les échantillons sont stockés par le microcontrôleur 84A.

En complément, lors de l'étape 220, chaque deuxième module 62A, 62B, 62C calcule respectivement, à l'aide du microcontrôleur 84A, 84B, 84C correspondant, et de manière périodique l'énergie active EA1, EA2, EA3, EB1, EB2, EB3, EC1, EC2, EC3 pour chacune des trois phases à partir des valeurs des tensions V1, V2, V3 mesurées et reçues du module primaire 60 via le premier message M1 et des valeurs des intensités IA1, IA2, IA3, IB1, IB2, IB3, IC1, IC2, IC3 mesurées par le capteur de courant 83A, 83B, 83C. La période de calcul des énergies actives EA1, EA2, EA3 est égale à la période $P_{tension}$, soit par exemple 20 ms. De même à partir des valeurs de tension V1, V2, V3 et de courant IA1, IA2, IA3, IB1, IB2, IB3, IC1, IC2, IC3, chaque deuxième module 62A, 62B, 62C est apte à calculer respectivement les puissances instantanées électriques QA1, QA2, QA3, QB1, QB2, QB3, QC1, QC2, QC3 des trois phases.

Lors d'une étape 230, chaque deuxième module 62A, 62B, 62C émet un deuxième message M2A, M2B, M2C qui lui est propre suivant l'ordonnancement décrit lors de la présentation de l'étape d'initialisation. Le deuxième message M2A, M2B, M2C contient respectivement les échantillons des intensités mesurées IA1, IA2, IA3 ; IB1, IB2, IB3 ; IC1, IC2, IC3.

En complément, lors de l'étape 230, le deuxième message M2A, M2B, M2C contient les valeurs correspondantes d'énergie électrique EA1, EA2, EA3, EB1, EB2, EB3, EC1, EC2, EC3 et de puissance électrique QA1, QA2, QA3, QB1, QB2, QB3, QC1, QC2, QC3 calculées.

Puis, lors d'une étape 240, le troisième module 63 qui est en écoute des deuxièmes messages M2A, M2B, M2C réceptionne ces deuxièmes messages. Les échantillons des intensités IA1, IA2, IA3, IB1, IB2, IB3, IC1, IC2, IC3 contenus dans les deuxièmes messages M2A, M2B, M2C correspondant sont alors récupérés.

En complément, lors de l'étape 240 les valeurs d'énergie électrique et de puissance électrique sont reçues et lors de l'étape 250 les sommes d'énergie et de puissance électrique sont calculées afin de déterminer l'énergie et la puissance dans le conducteur primaire 34, 36, 38.

Le troisième module 63 calcule ensuite, lors de l'étape 250, à partir des échantillons reçus, la somme des intensités des courants circulant dans chaque conducteur secondaire 42A, 44A, 46A, 42B, 44B, 46B, 42C, 44C, 46C à l'aide de l'organe de calcul 104, afin d'obtenir la valeur de l'intensité du courant circulant dans le conducteur primaire 34, 36, 38.

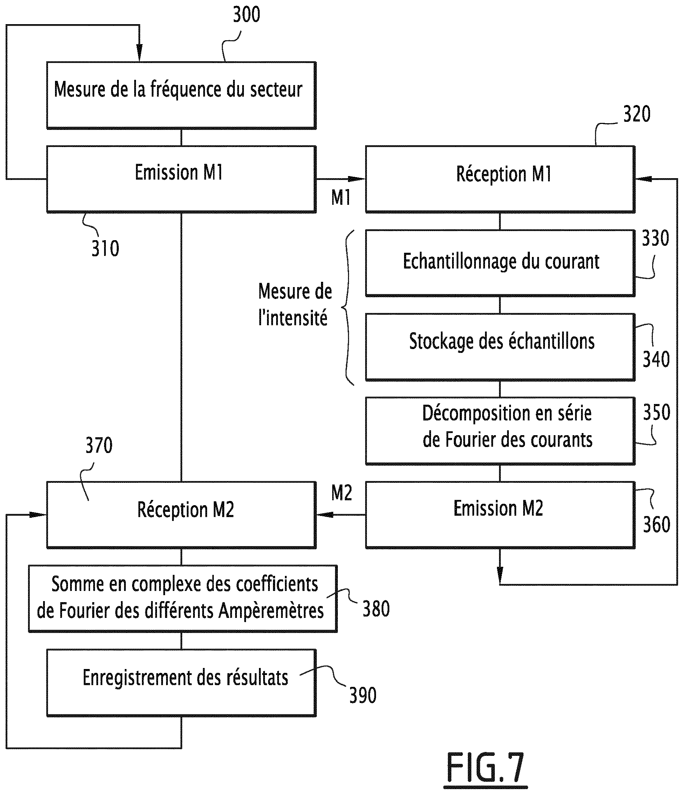

Le procédé de calcul selon le deuxième mode de réalisation va maintenant être décrit à l'aide de la figure 7.

Lors d'une étape 300, le premier module 60 mesure la fréquence F de la tension triphasée, c'est-à-dire la fréquence des tensions V1, V2, V3 des conducteurs primaires de départ 34, 36, 38. Cette mesure de la fréquence F est effectuée à l'aide de l'organe de mesure 66. Le premier module 60 envoie donc, lors d'une étape 310 analogue à l'étape 200, un premier message M1 similaire à celui décrit précédemment, sachant que ce message M1 contient aussi dans son champ de données la fréquence F de la tension triphasée, ou en variante la période d'échantillonnage $P_{ECH}$ utilisée pour l'échantillonnage des intensités mesurées par chaque capteur de courant 83A, 83B, 83C. L'inverse de la période d'échantillonnage $P_{ECH}$ est un multiple de la fréquence F. La fréquence d'échantillonnage $F_{ECH}$ est, par exemple, choisie avec une valeur 36 fois supérieure à celle de la fréquence F. A la fin de l'étape 310, le premier module 60 attend un temps prédéterminé avant de recommencer la mesure de la fréquence F et de réémettre le premier message M1, il attend approximativement une seconde.

L'étape suivante 320 de réception du message M1 est similaire à l'étape 210 décrite précédemment.

Puis, lors d'une étape 330, l'échantillonnage de l'intensité sur plusieurs périodes $P_{tension}$ de la tension triphasée est effectué de manière synchrone pour tous les capteurs de courants 83A, 83B, 83C. Dans l'exemple considéré, l'échantillonnage est effectué sur cinq périodes de la tension triphasée $P_{tension}$. La valeur de la fréquence d'échantillonnage $F_{ECH}$ est connue, cette valeur ayant été transmise dans le message M1 ou ayant été calculée à partir de la fréquence F de la tension triphasée transmise dans le premier message M1.

Au cours d'une étape suivante 340, les échantillons sont stockés en mémoire par le microcontrôleur 84A, 84B, 84C, et ensuite, lors d'une étape 350, une compression des échantillons est effectuée afin de limiter la quantité de données transmise par les deuxièmes messages M2A, M2B, M2C. L'étape de compression 350 va être décrite pour le deuxième module 62A, est identique pour chaque deuxième module 62A, 62B, 62C en remplaçant la lettre A par respectivement la lettre B, respectivement C.

Lors de l'étape de compression 350, le microcontrôleur 84A calcule, par exemple, un nombre prédéterminé K de premiers coefficients complexes $Re(IAiHj)$, $Im(IAiHj)$ de la décomposition en série de Fourier des trois courants IA1, IA2, IA3 des trois phases, où i est le numéro égal à 1, 2 ou 3 de la phase, et j est compris entre 1 et K. Le nombre prédéterminé K est de préférence égal à 5 et correspond à un rang prédéterminé d'harmoniques, c'est-à-dire au nombre d'harmoniques considérées pour les calculs, c'est-à-dire encore à une précision de calcul.

Les coefficients de la décomposition en série de Fourier sont, par exemple, obtenus par des opérations de corrélation sur les échantillons des valeurs mesurées. Plus précisément, Le coefficient réel du fondamental, également noté $Re(IAiH1)$, est une corrélation, sur une durée égale à la période $P_{tension}$ de la tension triphasée, entre les échantillons du signal de l'intensité IAi et un cosinus de fréquence égal à la fréquence F de la tension triphasée, où IAi représente l'intensité de la phase numéro i, i étant égal à 1, 2 ou 3. Le coefficient imaginaire du fondamental, également noté $Im(IAiH1)$, est une corrélation, sur une durée égale à la période $P_{tension}$, entre les échantillons du signal de l'intensité IAi et un sinus de fréquence égal à la fréquence F.

Le coefficient réel de l'harmonique numéro j, noté Re(IAiHj), j étant compris entre 2 et K, est la corrélation, sur une durée égale à la période $P_{tension}$, entre les échantillons du signal de l'intensité IAi et un cosinus de fréquence égal à j fois la fréquence F. Le coefficient imaginaire de l'harmonique numéro j, noté Im(IAiHj), j étant compris entre 2 et K, est la corrélation, sur une durée égale à la période $P_{tension}$, entre les échantillons du signal de l'intensité IAi et un sinus de fréquence égal à j fois la fréquence F.

Le microcontrôleur calcule ainsi les coefficients complexes Re(IAiHj), Im(IAiHj), i allant de 1 à 3 et j de 1 à K, des décompositions en série de Fourier des trois intensités IA1, IA2, IA3 pour le fondamental et les harmoniques 2 à K.

Ces coefficients complexes de la décomposition en série de Fourier sont calculés, par exemple, comme représenté à la figure 5, sur les cinq premières périodes P1, P2, P3, P4, P5 de la tension triphasée, puis moyennés sur ces cinq périodes afin de diminuer le bruit de mesure. Cette méthode permet d'avoir un nombre suffisant de points de mesure afin d'avoir une mesure précise qui ne dépend pas du bruit. La mesure du courant est effectuée sur les 5 premières périodes P1, P2, P3, P4, P5 après le top de synchronisation, ces périodes étant représentées par des traits verticaux à la figure 5 et chaque période étant numérotée.

En complément, lors de l'étape 350, les valeurs des énergies électriques EA1, EA2, EA3, EB1, EB2, EB3, EC1, EC2, EC3 réelles et des puissances QA1, QA2, QA3, QB1, QB2, QB3, QC1, QC2, QC3 complexes selon chacune des harmoniques sont calculées de manière identique à ce qui a été décrit précédemment pour l'étape 220.

Lors d'une étape 360, similaire à l'étape 230, chaque deuxième module 62A, 62B, 62C émet le deuxième message M2A, M2B, M2C. Toutefois, dans ce cas, le deuxième message M2A, M2B, M2C contient respectivement la valeur des coefficients complexes Re(IAiHj), Im(IAiHj), Re(IBiHj), Im(IBiHj), Re(ICiHj), Im(ICiHj), i allant de 1 à 3 et j de 1 à K par pas de 1, des décompositions en série de Fourier des trois intensités IA1, IA2, IA3 ; IB1, IB2, IB3 ; IC1, IC2, IC3 pour le fondamental H1 et les harmoniques 2 à K, au lieu des échantillons des intensités mesurées.

Après avoir transmis les deuxièmes messages M2A, M2B, M2C, chaque deuxième module 62A, 62B, 62C revient à l'étape 320 de réception du premier message M1.

Lors d'une étape suivante 370, le troisième module 63 est en écoute des deuxièmes messages M2A, M2B, M2C et réceptionne les deuxièmes messages M2A, M2B, M2C via son antenne 102. Puis le troisième module 63 enregistre et horodate à l'aide de son unité 105 les coefficients complexes Re(IAiHj), Im(IAiHj), Re(IBiHj), Im(IBiHj), Re(ICiHj), Im(ICiHj), i allant de 1 à 3 et j de 1 à K par pas de 1, des décompositions en série de Fourier des trois intensités IA1, IA2, IA3 ; IB1, IB2, IB3 ; IC1, IC2, IC3 pour le fondamental et les harmoniques 2 à K.

Suite à la réception des deuxièmes messages M2A, M2B, M2C effectuée à l'étape 370, les calculs des grandeurs électriques sont effectués lors de l'étape 380 et les valeurs suivantes sont obtenues :

+ le module du fondamental de chacune des phases du courant de sortie du transformateur :

- la partie réelle du fondamental de la phase i, i allant de 1 à 3, du courant en sortie de transformateur est calculée selon l'équation suivante :

$$Re(IiH1) = Re(IAiH1) + Re(IBiH1) + Re(ICiH1) \qquad (1)$$

- la partie imaginaire du fondamental de la phase i, i allant de 1 à 3, du courant en sortie de transformateur est ensuite calculée selon l'équation suivante :

$$Im(IiH1) = Im(IAiH1) + Im(IBiH1) + Im(ICiH1) \qquad (2)$$

- le module du fondamental de chacune des phases du courant de sortie du transformateur est enfin obtenu d'après les équations suivantes :

$$I1H1 = \sqrt{( [Re(I1H1)]^2 + [Im(I1H1)]^2 )} \qquad (3)$$

$$I2H1 = \sqrt{( [Re(I2H1)]^2 + [Im(I2H1)]^2 )} \qquad (4)$$

$$I3H1 = \sqrt{( [Re(I3H1)]^2 + [Im(I3H1)]^2 )} \qquad (5)$$

+ les modules des harmoniques de chacune des phases du courant de sortie du transformateur :

- la partie réelle de l'harmonique j, j allant de 2 à K de la phase i, i allant de 1 à 3 du courant en sortie de transformateur est calculée à l'aide de l'équation suivante :

$$Re(IiHj) = Re(IAiHj) + Re(IBiHj) + Re(ICiHj) \tag{6}$$

- la partie Imaginaire de l'harmonique j, j allant de 2 à K de la phase i, i allant de 1 à 3 du courant en sortie de transformateur est ensuite calculée selon l'équation suivante :

$$Im(IiHj) = Im(IAiHj) + Im(IBiHj) + Im(ICiHj) \tag{7}$$

- les modules des harmoniques de chacune des phases du courant de sortie du transformateur sont enfin obtenus d'après les équations suivantes :

$$I1Hj = \sqrt{([Re(I1Hj)]^2 + [Im(I1Hj)]^2)} \tag{8}$$

$$I2Hj = \sqrt{([Re(I2Hj)]^2 + [Im(I2Hj)]^2)} \tag{9}$$

$$I3Hj = \sqrt{([Re(I3Hj)]^2 + [Im(I3Hj)]^2)} \tag{10}$$

+ le module du fondamental et des harmoniques du courant de neutre en sortie du transformateur, j allant de 1 à K :

- les valeurs complexes du fondamental du courant de neutre en sortie du transformateur sont calculées selon les équations suivantes :

$$Re(InHj) = Re(I1Hj) + Re(I2Hj) + Re(I3Hj) \tag{11}$$

$$Im(InHj) = Im(I1Hj) + Im(I2Hj) + Im(I3Hj) \tag{12}$$

- le module du fondamental du courant de neutre en sortie du transformateur est alors obtenu à l'aide de l'équation suivante :

$$InHj = \sqrt{([Re(InHj)]^2 + [Im(InHj)]^2)} \tag{13}$$

+ une valeur approchée des courants Irms de chacune des phases du transformateur est aussi obtenue à l'aide des équations suivants, avec dans l'exemple donné K= 5 :

$$Irms1 = \sqrt{(([I1H1]^2 + [I1H2]^2 + [I1H3]^2 + [I1H4]^2 [Im(I1H5)]^2) / 2)} \tag{14}$$

$$Irms2 = \sqrt{(([I2H1]^2 + [I2H2]^2 + [I2H3]^2 + [I2H4]^2 [Im(I2H5)]^2) / 2)} \tag{15}$$

$$Irms3 = \sqrt{(([I3H1]^2 + [I3H2]^2 + [I3H3]^2 + [I3H4]^2 [Im(I3H5)]^2) / 2)} \tag{16}$$

Le troisième module 63 est aussi apte au cours de l'étape 380 à calculer, le module du fondamental de chacune des phases du courant de chacun des départs 40A, 40B, 40C, les modules des harmoniques de chacune des phases du courant de chacun des départs 40A, 40B, 40C, le module du fondamental du courant de neutre de chacun des départs 40A, 40B, 40C, les modules des harmoniques du courant de neutre de chacun des départs 40A, 40B, 40C, les modules des harmoniques du courant de neutre général.

En complément lors de l'étape 380 et de manière analogue à l'étape 250, des sommes d'énergies électriques réelles EA1, EA2, EA3, EB1, EB2, EB3, EC1, EC2, EC3 et de puissance, électrique, complexe QA1, QA2, QA3, QB1, QB2, QB3, QC1, QC2, QC3 sont effectuées de manière analogue à ce qui a été présenté pour les courants.

Enfin lors d'une étape 390, le troisième module 63 enregistre dans son unité 105 les résultats des différents calculs effectués. En complément, les grandeurs mesurées et calculées par le système de calcul 20 sont ensuite affichées sur l'écran de l'interface homme-machine 106 du troisième module 63. Ces grandeurs sont affichées sous forme de valeurs numériques et/ou sous forme de courbes.

A la suite de l'étape 390, le troisième module 63 se remet en écoute des deuxièmes messages M2A, M2B, M2C.

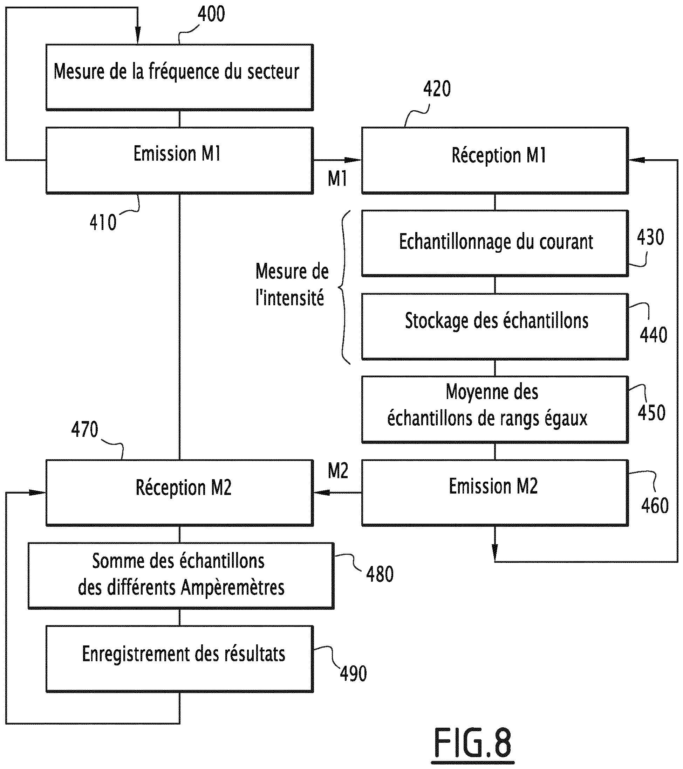

Le procédé de calcul selon le troisième mode de réalisation va maintenant être décrit à l'aide de la figure 8.

Lors d'une étape 400 similaire à l'étape 300, le premier module 60 mesure la fréquence F. Puis, de manière analogue à ce qui a été décrit pour l'étape 310, le premier module 60 émet le premier message M1 lors d'une étape 410.

Lors d'une étape 420, la réception du premier message M1 est effectuée de manière analogue à ce qui a été décrit pour l'étape 320. Puis, lors des étapes 430 et 440, l'échantillonnage du courant et le stockage des échantillons est effectué, de manière analogue à ce qui a été décrit dans les étapes 330 et 340 respectivement.

L'échantillonnage du courant est effectué à l'étape 430 sur plusieurs périodes $P_{tension}$, et plus particulièrement sur les cinq premières périodes P1, P2, P3, P4, P5. Les échantillons sont acquis successivement sur plusieurs périodes $P_{tension}$ et suivant des valeurs croissantes d'un rang d'échantillonnage au cours d'une période $P_{tension}$ donnée, la valeur du rang étant réinitialisée à la fin de chaque période $P_{tension}$. Autrement dit, pour chaque période, la valeur du rang est croissante en fonction du temps, c'est-à-dire que le premier échantillon de la période P1 a le rang 1 de même que le premier échantillon des périodes P2, P3, P4, P5 puis le deuxième échantillon de la période P1 a le rang 2, de même que le deuxième échantillon des périodes P2, P3, P4, P5 et ainsi de suite. Par exemple, lorsque la fréquence d'échantillonnage $F_{ECH}$ est choisie 36 fois supérieure à la fréquence F, on aura, pour les cinq périodes P1, P2, P3, P4, P5, 36 échantillons dont les rangs augmentent de 1 en 1 de façon croissante avec le temps, de 1 à 36.

Lors de l'étape 450, une moyenne des échantillons présentant une même valeur du rang d'échantillonnage est effectuée sur lesdites périodes, ceci afin d'obtenir des échantillons moyens.

Lors de l'étape 460, le fonctionnement est similaire à celui de l'étape 360, à la différence que chaque deuxième message M2A, M2B, M2C contient la valeur des échantillons moyens au lieu des coefficients de décomposition en série de Fourier.

Lors d'une étape 470, les deuxièmes messages M2A, M2B, M2C sont réceptionnés et le fonctionnement de cette étape est analogue à celui de l'étape 370, à la différence que les valeurs reçues sont des échantillons moyens, et non des coefficients de décomposition en série de Fourier.

Suite à la réception des deuxièmes messages effectuée à l'étape 470 par le troisième module 63, les calculs des grandeurs électriques sont effectués à l'aide de l'organe de calcul 104 dans une étape 480, au cours de laquelle est effectuée la somme des échantillons mesurés par les différents capteurs de courants 83A, 83B, 83C, ceci afin de calculer la valeur de l'intensité du courant en sortie du transformateur 18.

Enfin, une dernière étape 490 est analogue à l'étape 390 décrite précédemment.

A la suite de l'étape 490, le troisième module 63 se remet en écoute des deuxièmes messages M2A, M2B, M2C.

Une fois les calculs effectués lors des étapes 380 et 480 et avec une installation similaire à celle de la figure 2, le système de calcul 20 et le procédé de calcul selon l'invention permettent donc d'obtenir la valeur de l'intensité du courant en sortie du transformateur, sans utiliser de capteur de courant au niveau de la sortie du transformateur.

En variante, on utilise des moyens de compressions tels que ceux décrits précédemment aux étapes 440 et 540 afin de transmettre les tensions V1, V2, V3. Dans le cas où le moyen de compression utilisé est une décomposition en série de Fourier, le premier module 60 comprend un logiciel de compression propre à calculer un nombre prédéterminé K des premiers coefficients $Re\_j(Vi)$, $Im\_j(Vi)$ de la décomposition en série de Fourier de chacune des tensions V1, V2, V3 des trois phases, où i est le numéro égal à 1, 2 ou 3 de la phase, et j est compris entre 1 et K. Le nombre prédéterminé K est de préférence égal à 5. Les coefficients de la décomposition en série de Fourier sont, par exemple, obtenus par des opérations de corrélation sur les échantillons des valeurs mesurées comme expliqué précédemment dans le cas des courants.

En complément les sommes de puissances électriques complexes QA1, QA2, QA3, QB1, QB2, QB3, QC1, QC2, QC3 et d'énergies électriques réelles EA1, EA2, EA3, EB1, EB2, EB3, EC1, EC2, EC3 sont calculées. Pour cela le module 63 utilise les données envoyées par le message M1 et qui sont relatives aux tensions V1, V2, V3.

En complément, le champ de données du premier message M1 contient les valeurs des moyennes quadratiques, également notées RMS (de l'anglais *Roof Mean Square)*, de chacune des trois tensions V1, V2, V3.

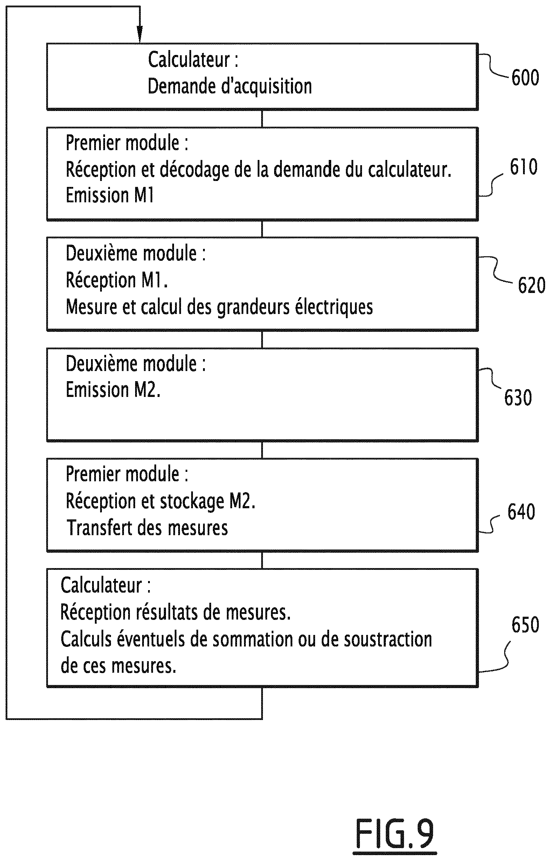

Le procédé de calcul selon le quatrième mode de réalisation va maintenant être décrit à l'aide de la figure 9.

Selon le quatrième mode de réalisation, le système de calcul 20 comprend un calculateur, non représenté, propre à transmettre, lors d'une étape 600, au premier module 60, une demande d'acquisition des deuxièmes messages M2A, M2B, M2C. Lorsque l'envoi des deuxièmes messages M2A, M2B, M2C est demandé par le calculateur, le premier module 60 reçoit cette demande lors d'une étape 610 et envoie par l'intermédiaire du champ de données du premier message M1 la requête à chaque deuxième module 62A, 62B, 62C.

Puis lors d'une étape 620, la réception du premier message M1 et la mesure du courant sont effectuées par chaque deuxième module 62A, 62B, 62C de manière similaire à ce qui a été décrit dans les étapes 210 et 220.

Lors d'une étape suivante 630, chaque deuxième module 62A, 62B, 62C élabore un deuxième message M2A, M2B, M2C et le transmet de manière similaire à ce qui a été décrit pour l'étape 230.

Les grandeurs mesurées et calculées, transmises via les deuxièmes messages M2A, M2B, M2C au troisième module 63, sont lors d'une étape 640 reçues et stockées dans une table de résultats et transmises au calculateur.

Enfin, le calculateur effectue lors d'une étape 650 des opérations de calcul, telles que des sommes d'intensités, des sommes de puissances ou des sommes d'énergies, comme décrit précédemment pour l'étape 250. Le calculateur est propre à effectuer une gestion centralisée des grandeurs mesurées et calculées. A l'issue de l'étape 650, le calculateur retourne au besoin à l'étape 600, afin de demander une nouvelle acquisition des grandeurs mesurées par les deuxièmes modules.

Le quatrième mode de réalisation décrit ci-dessus est une adaptation du premier mode de réalisation, et l'homme du métier comprendra que des adaptations analogues des deuxième et troisième modes de réalisation sont possibles.

De plus, chaque deuxième message M2A, M2B, M2C contient l'identifiant du deuxième module 62A, 62B, 62C qui l'envoie.

Selon une variante, lors de l'étape 200, le premier module 60 demande par l'intermédiaire du premier message M1 l'envoi des deuxièmes messages M2A, M2B, M2C. Le premier message M1 contient alors un champ spécifique de requête et les intensités mesurées et/ou les valeurs calculées sont envoyées par l'intermédiaire des deuxièmes messages M2A, M2B, M2C au troisième module 63 seulement lorsque ce champ spécifique est présent dans le premier message M1. Ainsi, le nombre de messages radioélectriques diminue fortement ce qui limite les risques de brouillage sur d'autres applications et permet d'optimiser l'énergie des deuxièmes modules 62A, 62B, 62C.

Le système de calcul 20 selon l'invention permet de réaliser des mesures synchronisées des courants circulant dans chaque départ, et il est ainsi possible de sommer les valeurs mesurées ou les grandeurs calculées à partir de ces valeurs d'intensités telles que l'énergie ou la puissance instantanée.

L'ensemble des modules 60, 62A, ..., 62C, 63 sont reliés entre eux par des liaisons radioélectriques par l'intermédiaire de leurs émetteurs et/ou récepteurs radioélectriques 70, 88A, ..., 88C, 102 respectif, ce qui permet de faciliter l'installation du système de calcul 20 dans le poste de transformation 10.

La compression des données relatives aux tensions et aux intensités mesurées permet de limiter la quantité de données transmises via les liaisons radioélectriques, et de limiter ainsi la propre consommation d'énergie du système de calcul 20. En outre, la compression des données permet de réduire la sensibilité du système de calcul 20 à des perturbations radioélectriques de type brouillage ou perturbation de compatibilité électromagnétique, également appelée perturbation CEM.

L'ordonnancement des deuxièmes modules permet de réduire les interférences radioélectriques entre les modules secondaires 62A, ..., 62C.

Selon un autre mode de réalisation, non représenté, le premier module 60 et le troisième module 63 ne forment qu'un seul module réalisant l'émission des premiers messages M1, la réception des deuxièmes messages M2A, M2B, M2C et les calculs des grandeurs électriques. Ceci permet alors de réduire le coût du système de calcul 20.

Les autres avantages de ce mode de réalisation sont identiques à ceux du premier mode de réalisation décrit précédemment. Le fonctionnement de ce mode de réalisation est par ailleurs identique à celui décrit précédemment.

Dans l'exemple de réalisation des figures 1 à 9 décrit précédemment, le réseau électrique 12 est un réseau triphasé, et le courant mesuré par l'intermédiaire du système de calcul 20 est un courant triphasé. L'homme du métier comprendra bien entendu que l'invention s'applique également à un réseau électrique monophasé et à la mesure d'un courant alternatif monophasé.

On conçoit ainsi que le système de calcul 20 selon l'invention est moins complexe et moins coûteux.

En variante, le deuxième message M2A contient en plus la moyenne IArms1, IArms2, IArms3 des valeurs des moyennes quadratiques des courants IA1, IA2, IA3. Il en va de même pour les autres deuxièmes messages M2A, M2B, M2C.

En variante, lorsqu'un départ du transformateur est difficilement accessible, le système de calcul 20 comprend N deuxièmes modules qui sont tous à l'exception d'un deuxième module associés à l'un des N départs, le dernier deuxième module étant associé à la sortie du transformateur. Ce système de calcul permet de déterminer l'intensité, la puissance ou l'énergie dans le départ difficilement accessible et qui n'est pas associé à un deuxième module. Dans d'autres opérations, certaines sommes sont alors replacées par des calculs de différences.

L'homme du métier comprendra en outre que l'expression « *propre à* » définit à chaque fois une caractéristique du type *"moyen plus fonction",* et doit alors s'interpréter de manière identique à l'expression « *configuré pour* ».

**Revendications**

1. Système (20) de calcul d'une grandeur électrique relative à une installation électrique (10) comprenant un conducteur électrique primaire (34, 36, 38, 39) et plusieurs conducteurs électriques secondaires (42A, 44A, 46A, 48A,...42N, 44N, 46N, 48N) reliés électriquement au conducteur électrique primaire (34, 36, 38, 39), le système de calcul (20) comprenant :

   - un premier module (60) comportant un émetteur radioélectrique (70),
   - une pluralité de deuxièmes modules (62A, 62B, 62C) chacun comportant un émetteur-récepteur radioélectrique (86A, 86B, 86C) et un capteur de courant (83A, 83B, 83C) propre à mesurer l'intensité d'un courant circulant dans au moins un conducteur correspondant parmi les conducteurs électriques primaire et secondaires,

      le premier module (60) comportant des premiers moyens (70, 72, 74) d'émission, à destination de chaque deuxième module (62A, 62B, 62C), d'un premier message (M1) de synchronisation temporelle,
      chaque deuxième module (62A, 62B, 62C) étant propre à mesurer au moins une valeur d'intensité au moyen de son capteur de courant dès réception du premier message et comportant des premiers moyens (84A, 86A, 88A ; 84B, 86B, 88B ; 84C, 86C, 88C) de réception du premier message et des deuxièmes moyens (84A, 88A ; 84B, 88B ; 84C, 88C) d'émission, à destination d'un troisième module (63), d'un deuxième message (M2A, M2B, M2C) contenant ladite au moins une valeur de l'intensité (IA1, IA2, IA3 ; IB1, IB2, IB3 ; IC1, IC2, IC3) mesurée par le capteur de courant (83A, 83B, 83C) correspondant dès réception du premier message, les valeurs d'intensité (IA1, IA2, IA3 ; IB1, IB2, IB3 ; IC1, IC2, IC3) étant mesurées quasi-simultanément par les différents capteurs de courant (83A, 83B, 83C), c'est-à-dire avec une marge d'erreur de synchronisation inférieure à 10 μs, et
      le système de calcul (20) comprenant le troisième module (63), et le troisième module (63) comporte un récepteur radioélectrique (101) et des deuxièmes moyens (102, 104) de réception des deuxièmes messages (M2A, M2B, M2C),
      le troisième module (63) comprenant en outre un organe (104) de calcul de la grandeur électrique à partir des valeurs d'intensité (IA1, IA2, IA3, IB1, IB2, IB3, IC1, IC2, IC3) mesurées quasi-simultanément et reçues via lesdits deuxièmes messages (M2A, M2B, M2C),
      **caractérisé en ce que en ce que** chaque deuxième module (62A, 62B, 62C) est propre à transmettre le deuxième message (M2A, M2B, M2C) correspondant avec un ordonnancement prédéterminé d'envoi des deuxièmes messages (M2A, M2B, M2C) au troisième module (63), selon un numéro d'ordre différent attribué à chaque deuxième module (62A, 62B, 62C), chaque deuxième module (62A, 62B, 62C) recevant pendant une étape d'initialisation, de la part du premier module (60), un troisième message (M3) spécifique à chaque deuxième module (62A, 62B, 62C) et contenant le numéro d'ordre.

2. Système selon la revendication 1, **caractérisé en ce que** l'organe de calcul (104) est propre à calculer une somme des valeurs d'intensités (IA1, IA2, IA3, IB1, IB2, IB3, IC1, IC2, IC3) reçues via les deuxièmes messages (M2A, M2B, M2C).

3. Système selon l'une quelconque des revendications précédentes, **caractérisé en ce que** le premier module (60) comprend en outre un organe (66) de mesure de la tension (V1, V2, V3) circulant dans un conducteur correspondant parmi les conducteurs électriques primaire (34, 36, 38, 39) et secondaires (42A, 44A, 46A, 48A,...42N, 44N, 46N, 48N), et est propre à transmettre la valeur de la tension (V1, V2, V3) mesurée aux deuxièmes modules (62A, 62B, 62C) via le premier message (M1),

   **en ce que** chaque deuxième module (62A, 62B, 62C) comprend des moyens de calcul (84A, 84B, 84C) d'une puissance instantanée (QA1, QA2, QA3, QB1, QB2, QB3, QC1, QC2, QC3) à partir de la valeur de la tension (V1, V2, V3) reçue via le premier message (M1) et de la valeur d'intensité (IA1, IA2, IA3 ;IB1, IB2, IB3 ; IC1, IC2, IC3) mesurée par le capteur de courant (83A, 83B, 83C), et est propre à transmettre la valeur de la puissance électrique (QA1, QA2, QA3, QB1, QB2, QB3, QC1, QC2, QC3) calculée au troisième module (63) via le deuxième message (M2A, M2B, M2C), et
   **en ce que** l'organe de calcul (104) du troisième module (63) est propre à calculer une somme des valeurs de puissances (QA1, QA2, QA3, QB1, QB2, QB3, QC1, QC2, QC3) reçues.

4. Système selon la revendication 1, **caractérisé en ce que** le premier module (60) comprend en outre un organe de mesure de la tension (V1, V2, V3) circulant dans un conducteur correspondant parmi les conducteurs électriques primaire (34, 36, 38, 39) et secondaires (42A, 44A, 46A, 48A,...42N, 44N, 46N, 48N), et est propre à transmettre la valeur de la tension (V1, V2, V3) mesurée aux deuxièmes modules (62A, 62B, 62C) via le premier message (M1),

**en ce que** chaque deuxième module (62A, 62B, 62C) comprend des moyens (84A, 84B, 84C) de calcul d'une énergie électrique (EA1, EA2, EA3, EB1, EB2, EB3, EC1, EC2, EC3) à partir de la valeur de la tension (V1, V2, V3) reçue via le premier message (M1) et de la valeur d'intensité (IA1, IA2, IA3, IB1, IB2, IB3 , IC1, IC2, IC3) mesurée par le capteur de courant (83A, 83B, 83C), et est propre à transmettre la valeur de l'énergie (EA1, EA2, EA3, EB1, EB2, EB3, EC1, EC2, EC3) calculée au troisième module (63) via les deuxièmes messages (M2A, M2B, M2C), et

**en ce que** l'organe de calcul (104) du troisième module (63) est propre à calculer une somme des valeurs d'énergie (EA1, EA2, EA3, EB1, EB2, EB3, EC1, EC2, EC3) reçues.

5. Système selon l'une quelconque des revendications précédentes, **caractérisé en ce que** chaque capteur de courant (83A, 83B, 83C) est propre à mesurer l'intensité (IA1, IA2, IA3, IB1, IB2, IB3, IC1, IC2, IC3) du courant correspondant et chaque deuxième module (62A, 62B, 62C) comprend un organe d'échantillonnage (90A, 90B, 90C) propre à échantillonner l'intensité mesurée selon une fréquence d'échantillonnage ($F_{ECH}$).

6. Système selon la revendication 5, **caractérisé en ce que** le premier message (M1) contient la valeur de ladite fréquence d'échantillonnage ($F_{ECH}$), ladite valeur étant de préférence une valeur prédéterminée ou bien un multiple de la valeur de la fréquence (F) de la tension (V1, V2, V3) d'au moins un conducteur parmi les conducteurs électriques primaire (34, 36, 38, 39) et secondaires (42A, 44A, 46A, 48A,...42N, 44N, 46N, 48N).

7. Système selon l'une quelconque des revendications précédentes, **caractérisé en ce que** les deuxièmes modules (62A, 62B, 62C) comprennent des premiers moyens de compression (84A, 84B, 84C) propres à calculer des coefficients de la décomposition en série de Fourier de ladite valeur de l'intensité (IA1, IA2, IA3, IB1, IB2, IB3 , IC1, IC2, IC3) mesurée par le capteur de courant (83A, 83B, 83C) correspondant.

8. Système selon la revendication 5 ou 6, **caractérisé en ce que** les échantillons sont acquis successivement sur plusieurs périodes ($P_{tension}$) de ladite tension (V1, V2, V3), et suivant des valeurs croissantes d'un rang d'échantillonnage au cours d'une période ($P_{tension}$) donnée, la valeur du rang étant réinitialisée à la fin de chaque période ($P_{tension}$), et **en ce que** les deuxièmes modules (62A, 62B, 62C) comprennent des premiers moyens de compression (84A, 84B, 84C) des valeurs d'intensité (IA1, IA2, IA3, IB1, IB2, IB3 , IC1, IC2, IC3) mesurées par le capteur de courant (83A, 83B, 83C) correspondant, ces moyens de compression (84A, 84B, 84C) calculant la moyenne des échantillons présentant une même valeur de rang.

9. Système selon l'une des revendications précédentes, **caractérisé en ce que** le premier message (M1) contient une requête en demande de réception des valeurs d'intensité mesurées par les deuxièmes modules (62A, 62B, 62C).

10. Poste (10) de transformation d'un courant électrique présentant une première tension alternative en un courant électrique présentant une deuxième tension alternative, comprenant :

- un premier tableau (14) comportant au moins un conducteur électrique d'arrivée (24A, 26A, 28A, 24B, 26B, 28B) propre à être relié à un réseau électrique (12),
- un deuxième tableau (16) comportant au moins un conducteur électrique primaire de départ (34, 36, 38, 39) et plusieurs conducteurs électriques secondaires de départ (42A, 44A, 46A, 48A,...42N, 44N, 46N, 48N), chaque conducteur secondaire de départ (42A, 44A, 46A, 48A,...42N, 44N, 46N, 48N) étant connecté électriquement à un conducteur primaire de départ (34, 36, 38, 39) correspondant,
- un transformateur (18) électrique connecté entre le premier tableau (14) et le deuxième tableau (16) et propre à transformer le courant présentant la première tension alternative en le courant présentant la deuxième tension alternative, et
- un système de calcul (20) d'une grandeur électrique relative au deuxième tableau (16),

**caractérisé en ce que** le système de calcul (20) est conforme à l'une quelconque des revendications précédentes.

11. Procédé de calcul d'une grandeur électrique relative à une installation électrique (10), l'installation électrique (10) comprenant un conducteur électrique primaire (34, 36, 38, 39) et plusieurs conducteurs électriques secondaires (42A, 44A, 46A, 48A,...42N, 44N, 46N, 48N) reliés électriquement au conducteur électrique primaire, le procédé étant mis en oeuvre à l'aide d'un système de calcul (20) comportant :

- un premier module (60) comportant un émetteur radioélectrique (70),
- une pluralité de deuxièmes modules (62A, 62B, 62C) chacun comportant un émetteur-récepteur radioélectrique (86A, 86B, 86C) et un capteur de courant (83A, 83B, 83C) propre à mesurer l'intensité d'un courant (IA1, IA2, IA3, IB1, IB2, IB3 , IC1, IC2, IC3) circulant dans un conducteur correspondant parmi les conducteurs électriques primaire (34, 36, 38) et secondaires (42A, 44A, 46A, 48A,...42N, 44N, 46N, 48N),

le procédé comprenant les étapes suivantes :

- a) l'émission (200, 310, 410), par le premier module (60) et à chaque deuxième module (62A, 62B, 62C), d'un premier message (M1) de synchronisation temporelle de la mesure de l'intensité (IA1,..., IC3) du courant circulant dans les conducteurs primaires (34, 36, 38) ou secondaires (42A,..., 46N),
- b) la réception (210, 320, 420) du premier message (M1) par chaque deuxième module,
- c) la mesure (220) quasi-simultanée, de préférence avec une marge d'erreur de synchronisation inférieure à $10\mu$s, de l'intensité (IA1, ..., IC3) du courant circulant dans les conducteurs primaires (34, 36, 38) ou secondaires (42A, ..., 46N) correspondant par chaque capteur de courant dès réception du premier message,

le procédé comprenant en outre les étapes suivantes :

- d) l'émission (220, 460, 560) par chaque deuxième module (62A, 62B, 62C) et à destination d'un troisième module (63), d'un deuxième message (M2A, M2B, M2C) contenant au moins une valeur de l'intensité (IA1, ..., IC3) mesurée par le capteur de courant (83A, 83B, 83C) correspondant,
- e) la réception (240, 470, 370) des deuxièmes messages (M2A, M2B, M2C) par le troisième module (63),
- f) le calcul (250, 380, 480) de la grandeur électrique à partir des valeurs d'intensité (IA1, ..., IC3) mesurées quasi-simultanément et reçues via lesdits deuxièmes messages, c'est-à-dire avec une marge d'erreur de synchronisation inférieure à $10\mu$s,

et étant **caractérisé en ce que** chaque deuxième module (62A, 62B, 62C) transmet le deuxième message (M2A, M2B, M2C) correspondant avec un ordonnancement prédéterminé d'envoi des deuxièmes messages (M2A, M2B, M2C) au troisième module (63), selon un numéro d'ordre différent attribué à chaque deuxième module (62A, 62B, 62C), chaque deuxième module (62A, 62B, 62C) recevant, pendant une étape d'initialisation, de la part du premier module (60), un troisième message (M3) spécifique à chaque deuxième module (62A, 62B, 62C) et contenant le numéro d'ordre.

**12.** Procédé selon la revendication 11, **caractérisé en ce que** :

- lors de l'étape a), la tension (V1, V2, V3) d'un conducteur correspondant parmi les conducteurs électriques primaire (34, 36, 38) et secondaires (42A, ..., 48N) est mesurée, et le premier message (M1) comprend la valeur de cette tension mesurée,
- lors de l'étape c), une puissance électrique (QA1, QA2, QA3, QB1, QB2, QB3, QC1, QC2, QC3) et/ou une énergie (EA1, EA2, EA3, EB1, EB2, EB3, EC1, EC2, EC3) est calculée par le deuxième module (62A, 62B, 62C), à partir de la valeur de la tension (V1, V2, V3) mesurée au cours de l'étape a) et de la valeur d'intensité (IA1, ... IC3) mesurée par le capteur de courant (83A, 83B, 83C),
- lors de l'étape d), le deuxième message (M2) contient en outre la valeur de la puissance électrique (QA1, ..., QC3) et/ou de l'énergie (EA1, ..., EC3) calculées,
- lors de l'étape e), une somme des valeurs de puissance ou d'énergie reçues est en outre calculée par le troisième module (63).

**13.** Procédé selon la revendication 11 ou 12, **caractérisé en ce que**

- lors de la mesure de l'étape c), l'intensité mesurée (IA1, ..., IC3) est échantillonnée selon une fréquence d'échantillonnage ($F_{ECH}$) et les intensités mesurées sont décomposées en série de Fourier,
- lors du calcul de l'étape e), la grandeur électrique est calculée à partir des valeurs des coefficients de Fourier complexe obtenues à l'étape c) jusqu'à un rang prédéterminé d'harmoniques.

**14.** Procédé selon la revendication 11 ou 12, **caractérisé en ce que**

- lors de la mesure de l'étape c), l'intensité mesurée est échantillonnée selon une fréquence d'échantillonnage ($F_{ECH}$), les échantillons sont acquis successivement sur plusieurs périodes ($P_{tension}$) de la tension (V1, V2, V3) d'un conducteur correspondant parmi les conducteurs électriques primaire (34, 36, 38) et secondaires (42A, ..., 48N), et suivant des valeurs croissantes d'un rang d'échantillonnage au cours d'une période ($P_{tension}$) donnée, la valeur du rang étant réinitialisée à la fin de chaque période ($P_{tension}$), et une moyenne des échantillons présentant une même valeur de rang est effectuée,

- lors du calcul de l'étape e), la grandeur électrique est calculée à partir des valeurs moyennes des échantillons obtenues à l'étape c).

15. Procédé selon l'une quelconque des revendications 12 à 14, **caractérisé en ce que** lors de l'étape a) le premier message (M1) contient en outre une requête en demande de réception des valeurs d'intensité (IA1, IA2, IA3, IB1, IB2, IB3 , IC1, IC2, IC3) et/ou de puissances électriques (QA1, QA2, QA3, QB1, QB2, QB3, QC1, QC2, QC3) et/ou d'énergies (EA1, EA2, EA3, EB1, EB2, EB3, EC1, EC2, EC3) mesurées ou calculées par les deuxièmes modules (62A, 62B, 62C).

## Patentansprüche

1. System (20) zum Berechnen einer elektrischen Größe in Bezug auf eine elektrische Installation (10), umfassend einen primären elektrischen Leiter (34, 36, 38, 39) und mehrere sekundäre elektrische Leiter (42A, 44A, 46A, 48A,...42N, 44N, 46N, 48N), die elektrisch mit dem primären elektrischen Leiter (34, 36, 38, 39) verbunden sind, das Berechnungssystem (20) umfassend:

- ein erstes Modul (60), umfassend einen Funksender (70),
- eine Vielzahl von zweiten Modulen (62A, 62B, 62C), jeweils umfassend einen Funksendeempfänger (86A, 86B, 86C) und einen Stromsensor (83A, 83B, 83C), der geeignet ist, um die Stärke eines Stroms zu messen, der in mindestens einem entsprechenden Leiter von den primären und sekundären elektrischen Leitern fließt,

das erste Modul (60) umfassend erste Sendeeinrichtungen (70, 72, 74), um an jedes zweite Modul (62A, 62B, 62C) eine erste Nachricht (M1) zur Zeitsynchronisation zu senden,
wobei jedes zweite Modul (62A, 62B, 62C) geeignet ist, um nach Empfang der ersten Nachricht mindestens einen Intensitätswert mittels seines Stromsensors zu messen, und erste Empfangseinrichtungen (84A, 86A, 88A; 84B, 86B, 88B; 84C, 86C, 88C) der ersten Nachricht und zweite Sendeeinrichtungen (84A, 88A; 84B, 88B; 84C, 88C) an ein drittes Modul (63), einer zweiten Nachricht (M2A, M2B, M2C), die den mindestens einen Wert der Intensität (IA1, IA2, IA3; IB1, IB2, IB3; IC1, IC2, IC3) enthält, die von dem entsprechenden Stromsensor (83A, 83B, 83C) nach Empfang der ersten Nachricht gemessen wird, wobei die Stromwerte (IA1, IA2, IA3; IB1, IB2, IB3; IC1, IC2, IC3) von den verschiedenen Stromsensoren (83A, 83B, 83C) quasi-simultan gemessen werden, d. h. mit einer Synchronisationsfehlerspanne von weniger als 10 $\mu$s, und
das Rechensystem (20) das dritte Modul (63) umfasst, und das dritte Modul (63) einen Funkempfänger (101) und zweite Empfangseinrichtungen (102, 104) zum Empfangen der zweiten Nachrichten (M2A, M2B, M2C) umfasst,
das dritte Modul (63) ferner umfassend ein Element (104) zum Berechnen der elektrischen Größe anhand der Intensitätswerte (IA1, IA2, IA3, IB1, IB2, IB3, IC1, IC2, IC3), die quasi-simultan gemessen und über die zweiten Nachrichten (M2A, M2B, M2C) empfangen werden,
**dadurch gekennzeichnet, dass** jedes zweite Modul (62A, 62B, 62C) geeignet ist, um die entsprechende zweite Nachricht (M2A, M2B, M2C) mit einer vorbestimmten Reihenfolge des Sendens der zweiten Nachrichten (M2A, M2B, M2C) an das dritte Modul (63) zu übertragen, gemäß einer unterschiedlichen Ordnungsnummer, die jedem zweiten Modul (62A, 62B, 62C) zugeordnet ist, wobei jedes zweite Modul (62A, 62B, 62C) während eines Initialisierungsschritts von dem ersten Modul (60) eine dritte Nachricht (M3) empfängt, die für jedes zweite Modul (62A, 62B, 62C) spezifisch ist und die Ordnungsnummer enthält.

2. System nach Anspruch 1, **dadurch gekennzeichnet, dass** das Rechenelement (104) geeignet ist, um eine Summe der Intensitätswerte (IA1, IA2, IA3, IB1, IB2, IB3, IC1, IC2, IC3) zu berechnen, die über die zweiten Nachrichten (M2A, M2B, M2C) empfangen werden.

3. System nach einem der vorherigen Ansprüche, **dadurch gekennzeichnet, dass** das erste Modul (60) ferner ein Element (66) zum Messen der Spannung (V1, V2, V3) umfasst, die in einem entsprechenden Leiter von den primären (34, 36, 38, 39) und sekundären elektrischen Leitern (42A, 44A, 46A, 48A,...42N, 44N, 46N, 48N) fließt, und geeignet ist, um den Wert der gemessenen Spannung (V1, V2, V3) über die erste Nachricht (M1) an die zweiten Module (62A, 62B, 62C) zu übertragen,

dass jedes zweite Modul (62A, 62B, 62C) Berechnungseinrichtungen (84A, 84B, 84C) einer momentanen Leistung (QA1, QA2, QA3, QB1, QB2, QB3, QC1, QC2, QC3) anhand des Werts der Spannung (V1, V2, V3), die über die erste Nachricht (M1) empfangen wird, und des Stromwerts (IA1, IA2, IA3; IB1, IB2, IB3; IC1, IC2, IC3), die von dem Stromsensor (83A, 83B, 83C) gemessen wird, umfasst und geeignet ist, um den Wert der elektrischen Leistung (QA1, QA2, QA3, QB1, QB2, QB3, QC1, QC2, QC3) über die zweite Nachricht (M2A, M2B, M2C) an das dritte Modul (63) zu übertragen, und
dass das Rechenelement (104) des dritten Moduls (63) geeignet ist, um eine Summe der empfangenen Leistungswerte (QA1, QA2, QA3, QB1, QB2, QB3, QC1, QC2, QC3) zu berechnen.

4. System nach Anspruch 1, **dadurch gekennzeichnet, dass** das erste Modul (60) ferner ein Messelement der Spannung (V1, V2, V3) umfasst, die in einem entsprechenden Leiter von den primären (34, 36, 38, 39) und sekundären elektrischen Leitern (42A, 44A, 46A, 48A,...42N, 44N, 46N, 48N) fließt, und geeignet ist, um den Wert der gemessenen Spannung (V1, V2, V3) über die erste Nachricht (M1) an die zweiten Module (62A, 62B, 62C) zu übertragen,

dass jedes zweite Modul (62A, 62B, 62C) Berechnungseinrichtungen (84A, 84B, 84C) einer elektrischen Energie (EA1, EA2, EA3, EB1, EB2, EB3, EC1, EC2, EC3) anhand des Werts der über die erste Nachricht (M1) empfangenen Spannung (V1, V2, V3) und des Werts der Stromstärke (IA1, IA2, IA3, IB1, IB2, IB3, IC1, IC2, IC3), die von dem Stromsensor (83A, 83B, 83C) gemessen wird, und geeignet ist, den Wert der berechneten Energie (EA1, EA2, EA3, EB1, EB2, EB3, EC1, EC2, EC3) über die zweiten Nachrichten (M2A, M2B, M2C) an das dritte Modul (63) zu übertragen, und
dass das Berechnungselement (104) des dritten Moduls (63) geeignet ist, um eine Summe der empfangenen Energiewerte (EA1, EA2, EA3, EB1, EB2, EB3, EC1, EC2, EC3) zu berechnen.

5. System nach einem der vorherigen Ansprüche, **dadurch gekennzeichnet, dass** jeder Stromsensor (83A, 83B, 83C) geeignet ist, um die Intensität (IA1, IA2, IA3, IB1, IB2, IB3, IC1, IC2, IC3) des entsprechenden Stroms zu messen, und jedes zweite Modul (62A, 62B, 62C) ein Abtastelement (90A, 90B, 90C) umfasst, das geeignet ist, um die gemessene Intensität gemäß einer Abtastfrequenz ($F_{ECH}$) abzutasten.

6. System nach Anspruch 5, **dadurch gekennzeichnet, dass** die erste Nachricht (M1) den Wert der genannten Abtastfrequenz ($F_{ECH}$) enthält, wobei der Wert vorzugsweise ein vorbestimmter Wert oder ein Vielfaches des Werts der Frequenz (F) der Spannung (V1, V2, V3) von mindestens einem von den primären (34, 36, 38, 39) und sekundären elektrischen Leitern (42A, 44A, 46A, 48A,...42N, 44N, 46N, 48N) ist.

7. System nach einem der vorherigen Ansprüche, **dadurch gekennzeichnet, dass** die zweiten Module (62A, 62B, 62C) erste Komprimierungseinrichtungen (84A, 84B, 84C) umfassen, die geeignet sind, um Koeffizienten der Fourier-Reihenzerlegung des Stromwerts (IA1, IA2, IA3, IB1, IB2, IB3, IC1, IC2, IC3) zu berechnen, der von dem entsprechenden Stromsensor (83A, 83B, 83C) gemessen wird.

8. System nach Anspruch 5 oder 6, **dadurch gekennzeichnet, dass** die Abtastwerte nacheinander über mehrere Perioden ($P_{Spannung}$) der genannten Spannung (V1, V2, V3) und gemäß ansteigenden Werten eines Abtastrangs während einer gegebenen Periode ($P_{Spannung}$) erfasst werden, wobei der Wert des Rangs am Ende jeder Periode ($P_{Spannung}$) zurückgesetzt wird, und dass die zweiten Module (62A, 62B, 62C) erste Komprimierungseinrichtungen (84A, 84B, 84C) der Stromwerte (IA1, IA2, IA3, IB1, IB2, IB3, IC1, IC2, IC3) umfassen, die von dem entsprechenden Stromsensor (83A, 83B, 83C) gemessen werden, wobei diese Komprimierungseinrichtungen (84A, 84B, 84C) den Mittelwert der Abtastungen mit demselben Rangwert berechnen.

9. System nach einem der vorherigen Ansprüche, **dadurch gekennzeichnet, dass** die erste Nachricht (M1) eine Anfrage zur Anforderung des Empfangs der von den zweiten Modulen (62A, 62B, 62C) gemessenen Intensitätswerte enthält.

10. Station (10) zum Umwandeln eines elektrischen Stroms, der eine erste Wechselspannung aufweist, in einen elektrischen Strom der eine zweite Wechselspannung aufweist, umfassend:

- eine erste Tafel (14), umfassend mindestens einen ankommenden elektrischen Leiter (24A, 26A, 28A, 24B, 26B, 28B), der geeignet ist, um mit einem Stromnetz (12) verbunden zu werden,
- eine zweite Schalttafel (16), umfassend mindestens einen primären elektrischen Abgangsleiter (34, 36, 38, 39) und mehrere sekundäre elektrische Abgangsleiter (42A, 44A, 46A, 48A,...42N, 44N, 46N, 48N), wobei jeder sekundäre Abgangsleiter (42A, 44A, 46A, 48A,...42N, 44N, 46N, 48N) elektrisch mit einem entsprechenden primären Abgangsleiter (34, 36, 38, 39) verbunden ist,
- einen elektrischen Transformator (18), der zwischen der ersten Tafel (14) und der zweiten Tafel (16) verbunden ist und geeignet ist, um den Strom, der die erste Wechselspannung aufweist in den Strom umzuwandeln, der die zweite Wechselspannung aufweist, und
- ein System (20) zum Berechnen einer elektrischen Größe in Bezug auf die zweite Tabelle (16),

**dadurch gekennzeichnet, dass** das Berechnungssystem (20) gemäß einem der vorherigen Ansprüche ist.

11. Verfahren zum Berechnen einer elektrischen Größe in Bezug auf eine elektrische Anlage (10), die elektrische Anlage (10) umfassend einen primären elektrischen Leiter (34, 36, 38, 39) und mehrere sekundäre elektrische Leiter (42A, 44A, 46A, 48A,...42N, 44N, 46N, 48N), die elektrisch mit dem primären elektrischen Leiter verbunden sind, wobei das Verfahren mittels eines Berechnungssystems (20) durchgeführt wird, umfassend:

- ein erstes Modul (60), umfassend einen Funksender (70),
- eine Vielzahl von zweiten Modulen (62A, 62B, 62C), jeweils umfassend einen Funksendeempfänger (86A, 86B, 86C) und einen Stromsensor (83A, 83B, 83C), der geeignet ist, um die Stärke eines Stroms (IA1, IA2, IA3, IB1, IB2, IB3, IC1, IC2, IC3) zu messen, der in einem entsprechenden Leiter von den primären (34, 36, 38) und sekundären elektrischen Leitern (42A, 44A, 46A, 48A,...42N, 44N, 46N, 48N) fließt,
das Verfahren umfassend die folgenden Schritte:

a) Senden (200, 310, 410), durch das erste Modul (60) und an jedes zweite Modul (62A, 62B, 62C), einer ersten Nachricht (M1) zur zeitlichen Synchronisierung der Messung der Intensität (IA1 IC3) des Stroms, der in den primären (34, 36, 38) oder sekundären Leitern (42A, ..., 46N) fließt,
b) Empfangen (210, 320, 420) der ersten Nachricht (M1) durch jedes zweite Modul,
c) quasi-simultanes Messen (220), vorzugsweise mit einer Synchronisationsfehlermarge von weniger als 10 μs, der Intensität (IA1, ..., IC3) des Stroms, der in den entsprechenden primären (34, 36, 38) oder sekundären Leitern (42A, ..., 46N) fließt, durch jeden Stromsensor nach Empfangen der ersten Nachricht,

das Verfahren ferner umfassend die folgenden Schritte:

d) Senden (220, 460, 560) von jedem zweiten Modul (62A, 62B, 62C) und an ein drittes Modul (63) einer zweiten Nachricht (M2A, M2B, M2C), die mindestens einen Wert des Stroms (IA1, ..., IC3) enthält, der von dem entsprechenden Stromsensor (83A, 83B, 83C) gemessen wird,
e) Empfangen (240, 470, 370) der zweiten Nachrichten (M2A, M2B, M2C) durch das dritte Modul (63),
f) Berechnen (250, 380, 480) der elektrischen Größe aus den Stromwerten (IA1, ..., IC3), die quasi-simultan gemessen und über die zweiten Nachrichten empfangen werden, d. h. mit einer Synchronisationsfehlermarge von weniger als 10 μs,

und **dadurch gekennzeichnet, dass** jedes zweite Modul (62A, 62B, 62C) die entsprechende zweite Nachricht (M2A, M2B, M2C) mit einer vorbestimmten Reihenfolge des Sendens der zweiten Nachrichten (M2A, M2B, M2C) an das dritte Modul (63) überträgt, gemäß einer unterschiedlichen Ordnungsnummer, die jedem zweiten Modul (62A, 62B, 62C) zugeordnet ist, wobei jedes zweite Modul (62A, 62B, 62C) während eines Initialisierungsschritts von dem ersten Modul (60) eine dritte Nachricht (M3) empfängt, die für jedes zweite Modul (62A, 62B, 62C) spezifisch ist und die Ordnungsnummer enthält.

12. Verfahren nach Anspruch 11, **dadurch gekennzeichnet, dass**:

- in Schritt a) die Spannung (V1, V2, V3) eines entsprechenden Leiters von den primären (34, 36, 38) und sekundären elektrischen Leitern (42A, ..., 48N) gemessen wird, und die erste Nachricht (M1) den Wert dieser gemessenen Spannung enthält,
- in Schritt c) eine elektrische Leistung (QA1, QA2, QA3, QB1, QB2, QB3, QC1, QC2, QC3) und/oder eine Energie (EA1, EA2, EA3, EB1, EB2, EB3, EC1, EC2, EC3) durch das zweite Modul (62A, 62B, 62C) anhand des in Schritt a) gemessenen Werts der Spannung (V1, V2, V3) und des Werts der Stromstärke (IA1, ... IC3), die von dem Stromsensor (83A, 83B, 83C) gemessen wird, berechnet wird,

- in Schritt d) die zweite Nachricht (M2) ferner den Wert der berechneten elektrischen Leistung (QA1, QC3) und/oder der berechneten Energie (EA1, EC3) enthält,
- in Schritt e) zusätzlich eine Summe der empfangenen Leistungs- oder Energiewerte durch das dritte Modul (63) berechnet wird.

13. Verfahren nach Anspruch 11 oder 12, **dadurch gekennzeichnet, dass**

- bei der Messung in Schritt c) die gemessene Intensität (IA1, ..., IC3) mit einer Abtastfrequenz ($F_{ECH}$) abgetastet wird und die gemessenen Intensitäten in Fourier-Reihen zerlegt werden,
- bei der Berechnung in Schritt e) die elektrische Größe aus den in Schritt c) erhaltenen Werten der komplexen Fourier-Koeffizienten bis zu einem vorbestimmten Rang von Oberschwingungen berechnet wird.

14. Verfahren nach Anspruch 11 oder 12, **dadurch gekennzeichnet, dass**

- bei der Messung in Schritt c) die gemessene Intensität gemäß einer Abtastfrequenz ($F_{ECH}$) abgetastet wird, die Abtastungen nacheinander über mehrere Perioden ($P_{Spannung}$) der Spannung (V1, V2, V3) eines entsprechenden der primären (34, 36, 38) und sekundären elektrischen Leiter (42A, ...., 48N) und gemäß ansteigenden Werten eines Abtastrangs während einer gegebenen Periode ($P_{Spannung}$) erfasst werden, wobei der Wert des Rangs am Ende jeder Periode ($P_{Spannung}$) zurückgesetzt wird, und ein Mittelwert der Abtastungen mit demselben Rangwert gebildet wird,
- bei der Berechnung in Schritt e) die elektrische Größe aus den in Schritt c) erlangten Durchschnittswerten der Proben berechnet wird.

15. Verfahren nach einem der Ansprüche 12 bis 14, **dadurch gekennzeichnet, dass** in Schritt a) die erste Nachricht (M1) ferner eine Anfrage zur Anforderung eines Empfangs von Stromstärkenwerten (IA1, IA2, IA3, IB1, IB2, IB3, IC1, IC2, IC3) und/oder elektrischen Leistungen (QA1, QA2, QA3, QB1, QB2, QB3, QC1, QC2, QC3) und/oder Energien (EA1, EA2, EA3, EB1, EB2, EB3, EC1, EC2, EC3), die von den zweiten Modulen (62A, 62B, 62C) gemessen oder berechnet wurden, enthält.

## Claims

1. A system (20) for calculating an electric quantity relative to an electrical installation (10) comprising a primary electrical conductor (34, 36, 38, 39) and several secondary electrical conductors (42A, 44A, 46A, 48A, ..., 42N, 44N, 46N, 48N) electrically connected to the primary electrical conductor (34, 36, 38, 39), the calculating system (20) comprising:

- a first module (60) including a wireless transmitter (70),
- a plurality of second modules (62A, 62B, 62C), each including a wireless transceiver (86A, 86B, 86C) and a current sensor (83A, 83B, 83C) capable of measuring the intensity of a current circulating in at least a corresponding conductor from among the primary and secondary electrical conductors,
the first module (60) including transmission means (70, 72, 74) for transmitting a first time synchronization message (M1) to each second module (62A, 62B, 62C),
each second module (62A, 62B, 62C) being capable of measuring at least one intensity value using its current sensor upon reception of the first message and including first means (84A, 86A, 88A; 84B, 86B, 88B; 84C, 86C, 88C) for receiving the first message and second means (84A, 88A; 84B, 88B; 84C, 88C) for transmitting a second message (M2A, M2B, M2C), containing said at least one intensity value (IA1, IA2, IA3; IB1, IB2, IB3; IC1, IC2, IC3) measured by the corresponding current sensor (83A, 83B, 83C) upon reception of the first message, to a third module (63), the intensity values (IA1, IA2, IA3; IB1, IB2, IB3; IC1, IC2, IC3) being measured quasi-simultaneously by the various current sensors (83A, 83B, 83C), that is to say with a synchronization margin of error smaller than 10 $\mu$s, and
the calculating system (20) comprising the third module (63), and the third module (63) includes a wireless receiver (101), second means (102, 104) for receiving second messages (M2A, M2B, M2C),
the third module (63) further comprising a calculating unit (104) for calculating the electric quantity from intensity values (IA1, IA2, IA3; IB1, IB2, IB3; IC1, IC2, IC3) measured quasi-simultaneously and received via said second messages (M2A, M2B, M2C),
**characterized in that** each second module (62A, 62B, 62C) is capable of transmitting the second message (M2A, M2B, M2C) corresponding to a predetermined transmission order to the third module (63), according to an order number attributed to each second module (62A, 62B, 62C), each second module (62A, 62B, 62C) receiving, during an initializing step, a third message (M3) specific to each second module (62A, 62B, 62C) and comprising the order number.

2. The system according to claim 1, **characterized in that** the calculating unit (104) is capable of calculating a sum of the intensity values (IA1, IA2, IA3, IB1, IB2, IB3, IC1, IC2, IC3) received via the second messages (M2A, M2B, M2C).

3. The system according to any one of the preceding claims, **characterized in that** the first module (60) further comprises a measuring unit (66) for measuring the voltage (V1, V2, V3) circulating in a corresponding conductor from among the primary (34, 36, 38, 39) and secondary (42A, 44A, 46A, 48A, ..., 42N, 44N, 46N, 48N) electrical conductors, and is capable of sending the value of the measured voltage (V1, V2, V3) to the second modules (62A, 62B, 62C) via the first message (M1),

   **in that** each second module (62A, 62B, 62C) comprises calculating means (84A, 84B, 84C) for calculating an instantaneous power (QA1, QA2, QA3, QB1, QB2, QB3, QC1, QC2, QC3) from the value of the voltage (V1, V2, V3) received via the first message (M1) and the intensity value (IA1, IA2, IA3; IB1, IB2, IB3; IC1, IC2, IC3) measured by the current sensor (83A, 83B, 83C), and is capable of sending the calculated electric power value (QA1, QA2, QA3, QB1, QB2, QB3, QC1, QC2, QC3) to the third module (63) via the second message (M2A, M2B, M2C), and

   **in that** the calculating unit (104) of the third module (63) is capable of calculating a sum of the received power values (QA1, QA2, QA3, QB1, QB2, QB3, QC1, QC2, QC3).

4. The system according to claim 1, **characterized in that** the first module (60) further comprises a measuring unit for measuring the voltage (V1, V2, V3) circulating in a corresponding conductor from among the primary (34, 36, 38, 39) and secondary (42A, 44A, 46A, 48A, ..., 42N, 44N, 46N, 48N) electrical conductors, and is capable of sending the value of the measured voltage (V1, V2, V3) to the second modules (62A, 62B, 62C) via the first message (M1),

   **in that** each second module (62A, 62B, 62C) comprises calculating means (84A, 84B, 84C) for calculating an electric energy (EA1, EA2, EA3, EB1, EB2, EB3, EC1, EC2, EC3) from the value of the voltage (V1, V2, V3) received via the first message (M1) and the intensity value (IA1, IA2, IA3; IB1, IB2, IB3; IC1, IC2, IC3) measured by the current sensor (83A, 83B, 83C), and is capable of sending the calculated electric power value (EA1, EA2, EA3, EB1, EB2, EB3, EC1, EC2, EC3) to the third module (63) via the second message (M2A, M2B, M2C), and

   **in that** the calculating unit (104) of the third module (63) is capable of calculating a sum of the received energy values (EA1, EA2, EA3, EB1, EB2, EB3, EC1, EC2, EC3).

5. The system according to any one of the preceding claims, **characterized in that** each current sensor (83A, 83B, 83C) is capable of measuring the intensity (IA1, IA2, IA3, IB1, IB2, IB3, IC1, IC2, IC3) of the corresponding current and each second module (62A, 62B, 62C) comprises a sampling unit (90A, 90B, 90C) capable of sampling the measured intensity using a sampling frequency ($F_{ECH}$).

6. The system according to claim 5, **characterized in that** the first message (M1) contains the value of said sampling frequency ($F_{ECH}$), said value preferably being a predetermined value or a multiple of the value of the frequency (F) of the voltage (V1, V2, V3) of at least one conductor from among the primary (34, 36, 38, 39) and secondary (42A, 44A, 46A, 48A,...42N, 44N, 46N, 48N) electrical conductors.

7. The system according to any one of the preceding claims, **characterized in that** the second modules (62A, 62B, 62C) comprise first compression means (84A, 84B, 84C) capable of calculating coefficients of the decomposition of said intensity value (IA1, IA2, IA3, IB1, IB2, IB3 , IC1, IC2, IC3) measured by the corresponding current sensor (83A, 83B, 83C) into a Fourier series.

8. The system according to claim 5 or 6, **characterized in that** the samples are acquired successively over several periods ($P_{tension}$) of said voltage (V1, V2, V3), and according to increasing values of a sampling rank during a given period ($P_{tension}$), the rank value being reset at the end of each period ($P_{tension}$), and **in that** the second modules (62A, 62B, 62C) comprise first compression means (84A, 84B, 84C) for the intensity values (IA1, IA2, IA3, IB1, IB2, IB3 , IC1, IC2, IC3) measured by the corresponding current sensor (83A, 83B, 83C), those compression means (84A, 84B, 84C) calculating the mean of the samples having a same rank value.

9. The system according to one of the preceding claims, **characterized in that** the first message (M1) contains a reception request for the intensity values measured by the second modules (62A, 62B, 62C).

10. A transformer substation (10) for transforming an electrical current having a first alternating voltage into an electrical current having a second alternating voltage, comprising:

- a first panel (14) including at least one incoming electrical conductor (24A, 26A, 28A, 24B, 26B, 28B) capable of being connected to an electric network (12),
- a second panel (16) including at least one primary outgoing electrical conductor (34, 36, 38, 39) and several secondary outgoing electrical conductors (42A, 44A, 46A, 48A, ...42N, 44N, 46N, 48N), each secondary outgoing conductor (42A, 44A, 46A, 48A, ...42N, 44N, 46N, 48N) being electrically connected to a corresponding primary outgoing conductor (34, 36, 38, 39),
- an electric transformer (18) connected between the first panel (14) and the second panel (16) and capable of transforming the current with the first alternating voltage by the current having the second alternating voltage, and
- a system (20) for calculating an electric quantity relative to the second panel (16),

**characterized in that** the calculating system (20) is according to any one of the preceding claims.

11. A method for calculating an electric quantity relative to an electrical installation (10), the electrical installation (10) comprising a primary electrical conductor (34, 36, 38, 39) and several secondary electrical conductors (42A, 44A, 46A, 48A, ... 42N, 44N, 46N, 48N) electrically connected to the primary electrical conductor, the method being implemented using a calculating system (20) including:

- a first module (60) including a wireless transmitter (70),
- a plurality of second modules (62A, 62B, 62C), each including a wireless transceiver (86A, 86B, 86C) and a current sensor (83A, 83B, 83C) capable of measuring the intensity of a current (IA1, IA2, IA3, IB1, IB2, IB3 , IC1, IC2, IC3) circulating in a corresponding conductor from among the primary (34, 36, 38) and secondary (42A, 44A, 46A, 48A, ...42N, 44N, 46N, 48N) electrical conductors,

the method comprising the following steps:

- a) the transmission (200, 310, 410), by the first module (60) and to each second module (62A, 62B, 62C), of a first time synchronization message (M1) of the measurement of the intensity (IA1, IC3) of the current circulating in the primary (34, 36, 38) or secondary (42A, ..., 46N) conductors,
- b) reception (210, 320, 420) of the first message (M1) by each second module,
- c) the quasi-simultaneous measurement (220), preferably with a synchronization margin of error smaller than 10 $\mu$s, of the intensity (IA1, ..., IC3) of the current circulating in the corresponding primary (34, 36, 38) or secondary (42A, ..., 46N) conductors by each current sensor upon reception of the first message,

the method further comprising the following steps:

- d) the transmission (220, 460, 560), by each second module (62A, 62B, 62C) and to a third module (63), of a second message (M2A, M2B, M2C) containing at least one value of the intensity (IA1, ..., IC3) measured by the corresponding current sensor (83A, 83B, 83C),
- e) the reception (240, 470, 370) of the second messages (M2A, M2B, M2C) by the third module (63),
- f) the calculation (250, 380, 480) of the electric quantity from intensity values (IA1, ..., IC3) measured quasi-simultaneously and received via said second messages, that is to say with a margin of synchronization error smaller than 10$\mu$s, and

being **characterized in that** each second module (62A, 62B, 62C) transmits a second message (M2A, M2B, M2C) corresponding to a predetermined transmission order to the third module (63), according to an order number attributed to each second module (62A, 62B, 62C), each second module (62A, 62B, 62C) receiving, during an initializing step, a third message (M3) specific to each second module (62A, 62B, 62C) and comprising the order number.

12. The method according to claim 11, **characterized in that**:

- during step a), the voltage (V1, V2, V3) of a corresponding conductor from among the primary (34, 36, 38) and secondary (42A, ..., 48N) electrical conductors is measured, and the first message (M1) comprises the value of that measured voltage,
- during step c), an electric power (QA1, QA2, QA3, QB1, QB2, QB3, QC1, QC2, QC3) and/or an energy (EA1, EA2, EA3, EB1, EB2, EB3, EC1, EC2, EC3) is calculated by the second module (62A, 62B, 62C), from the value of the voltage (V1, V2, V3) measured during step a) and the intensity value (IA1, ..., IC3) measured by the current sensor (83A, 83B, 83C),
- during step d), the second message (M2) further contains the value of the calculated electric power (QA1, ..., QC3) and/or energy (EA1, ..., EC3),
- during step e), a sum of the received power or energy values is further calculated by the third module (63).

**13.** The method according to claim 11 or 12, **characterized in that**

- during the measurement in step c), the measured intensity (IA1, ..., IC3) is sampled using a sampling frequency ($F_{ECH}$) and the measured intensities are decomposed into a Fourier series,
- while during the calculation in step e), the electric quantity is calculated from values of the complex Fourier coefficients obtained in step c) up to a predetermined harmonic rank.

**14.** The method according to claim 11 or 12, **characterized in that**

- during the measurement in step c), the measured intensity is sampled using a sampling frequency ($F_{ECH}$), the samples are successively acquired over several periods ($P_{tension}$) of the voltage (V1, V2, V3) of a corresponding conductor from among the primary (34, 36, 38) and secondary (42A, ..., 48N) electrical conductors, and according to increasing values of a sampling rank during a given period ($P_{tension}$), the value of the rank being reset at the end of each period ($P_{tension}$), and a mean of the samples having a same rank value is done,
- while during the calculation in step e), the electric quantity is calculated from mean values of the samples obtained in step c).

**15.** The method according to any one of claims 12 to 14, **characterized in that** during step a), the first message (M1) further contains a reception request for the intensity (IA1, IA2, IA3, IB1, IB2, IB3 , IC1, IC2, IC3) and/or electric power (QA1, QA2, QA3, QB1, QB2, QB3, QC1, QC2, QC3) and/or energy (EA1, EA2, EA3, EB1, EB2, EB3, EC1, EC2, EC3) values measured or calculated by the second modules (62A, 62B, 62C).

<u>FIG.1</u>

**FIG.2**

FIG.3

M1

| Préambule 4 octets | SFD 1 octet | PHD 1 octet | Données n octets | CRC 2 octets |

$T_e$

$D_p$

$T_r$

t

Emission radio par émetteur

IT par récepteur

## FIG.4

FIG.5

EP 2 816 360 B1

| | |
|---|---|
| Emission M1 | 200 |
| Réception M1 | 210 |
| Mesure de l'intensité | 220 |
| Emission M2 | 230 |
| Réception M2 | 240 |
| Calcul grandeur électrique | 250 |

## FIG.6

300

| Mesure de la fréquence du secteur |

Emission M1 — M1 → | Réception M1 | 320

310

Mesure de
l'intensité

| Echantillonnage du courant | 330

| Stockage des échantillons | 340

| Décomposition en série de Fourier des courants | 350

370

| Réception M2 | ← M2 — | Emission M2 | 360

| Somme en complexe des coefficients de Fourier des différents Ampèremètres | 380

| Enregistrement des résultats | 390

## FIG.7

FIG.8

Calculateur :
Demande d'acquisition — 600

Premier module :
Réception et décodage de la demande du calculateur.
Emission M1 — 610

Deuxième module :
Réception M1.
Mesure et calcul des grandeurs électriques — 620

Deuxième module :
Emission M2. — 630

Premier module :
Réception et stockage M2.
Transfert des mesures — 640

Calculateur :
Réception résultats de mesures.
Calculs éventuels de sommation ou de soustraction
de ces mesures. — 650

FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2010119332 A1

- WO 2013017663 A1